# EUROPEAN PATENT APPLICATION

(11) **EP 4 435 489 A1**
(43) Date of publication of application: **25.09.2024**
(21) Application number: 24164482.2
(22) Date of filing: 19.03.2024
(51) Int. Cl.: G02B 13/16, G02F 1/13357, G03B 21/62, G02B 3/08

(54) **ARTIFICIAL WINDOW AND ARTIFICIAL SKYLIGHT**

(30) Priority: 20.03.2023 US 202318123688
(71) Applicant: Christie Digital Systems USA, Inc., Cypress, CA 90630 (US)
(72) Inventor: PRIEDE, Jordan Evalds Huxley, Waterloo, Ontario, N2J 0E7 (CA)
(74) Representative: Stöckeler, Ferdinand

(57) **Abstract**

An artificial and an artificial skylight is provided. In particular a device is provided that includes a collimating lens having a focal plane and a focal point. The focal plane is flat or curved dependent on given optical properties of the lens. The device further includes a sheet having a lens-facing front side and an opposing back side. The sheet is semi-transparent and has an image thereat, at least at the lens-facing front side. The image is located at about the focal plane of the lens. The device further includes at least one lamp located at the back side of the sheet, the sheet being between the collimating lens and the at least one lamp. The at least one lamp is configured to emit light towards the back side of the sheet, at least a portion of the light transmitted through the sheet towards the collimating lens.

## Description

### BACKGROUND

Artificial windows and/or artificial skylights are becoming more popular, however such artificial windows and/or artificial skylights are generally large, bulky, and heavy, and hence can be challenging to hang on walls or ceilings.

### BRIEF DESCRIPTIONS OF THE DRAWINGS

For a better understanding of the various examples described herein and to show more clearly how they may be carried into effect, reference will now be made, by way of example only, to the accompanying drawings in which:
FIG. 1 depicts an artificial window and/or an artificial skylight device, according to non-limiting examples.
FIG. 2 depicts paths of light through the device of FIG. 1, according to non-limiting examples.
FIG. 3 depicts the device of FIG. 1, at a different orientation, according to non-limiting examples.
FIG. 4 depicts an image of the device 100 of FIG. 1 when used as an artificial window, according to non-limiting examples.
FIG. 5 depicts an image of the device 100 of FIG. 1 when used as an artificial skylight, according to non-limiting examples
FIG. 6 depicts an array of lamps of the device of FIG. 1, according to non-limiting examples.
FIG. 7 depicts electronic components of the device of FIG. 1, according to non-limiting examples.
FIG. 8 a flowchart of a method for controlling at least one lamp of the device of FIG. 1, according to non-limiting examples.
FIG. 9 depicts a perspective front view of the device of FIG. 1 with an artificial sun in a first position, according to non-limiting examples.
FIG. 10 depicts a perspective front view of the device of FIG. 1 with an artificial sun in a second position, according to non-limiting examples.
FIG. 11 depicts a perspective rear view of the device of FIG. 1 with an artificial sun in a third position, according to non-limiting examples.
FIG. 12 depicts an artificial window and/or an artificial skylight device, according to non-limiting examples.
FIG. 13 depicts a system comprising a plurality of the devices of FIG. 1 tiled together, according to non-limiting examples.
FIG. 14A depicts the system of FIG. 13 but showing an optical effect of the system that may occur due to collimation of emitted light by individual devices when a viewer is located at a left side of the system of FIG. 13, according to non-limiting examples.
FIG. 14B depicts a portion of an image that is viewed by a viewer when the viewer is located at a left side of the system of FIG. 13, according to non-limiting examples.
FIG. 14C depicts the system of FIG. 13 but showing an optical effect of the system that may occur due to collimation of emitted light by individual devices when a viewer is located at a middle of the system of FIG. 13, according to non-limiting examples.
FIG. 14D depicts a portion of an image that is viewed by a viewer when the viewer is located at a middle of the system of FIG. 13, according to non-limiting examples.
FIG. 14E depicts the system of FIG. 13 but showing an optical effect of the system that may occur due to collimation of emitted light by individual devices when a viewer is located at a right side of the system of FIG. 13, according to non-limiting examples.
FIG. 14F depicts a portion of an image that is viewed by a viewer when the viewer is located at a right side of the system of FIG. 13, according to non-limiting examples.
FIG. 15 depicts a system comprising a plurality of the devices of FIG. 1 tiled together, according to alternative non-limiting examples.
FIG. 16 depicts a perspective front view of the device of FIG. 1 and showing various further features, according to non-limiting examples.
FIG. 17 depicts an artificial window and/or an artificial skylight device that includes a second sheet between a lens and a first sheet, according to non-limiting examples.
FIG. 18 examples of the second sheet of the device of FIG. 17, according to non-limiting examples.
FIG. 19 depicts a system comprising three devices of FIG. 17 tiled together, with different images on a second sheet to achieve a particular optical effect, according to non-limiting examples.
FIG. 20 depicts an artificial window and/or an artificial skylight device that includes one or more mirrors extending from a sheet thereof to extend a viewing angle, according to non-limiting examples.
FIG. 21 depicts an artificial window and/or an artificial skylight device that includes a mirror to double an image thereof to extend a viewing angle, according to non-limiting examples.
FIG. 22 depicts an example of an image doubled by the device of FIG. 21, according to non-limiting examples.
FIG. 23 depicts an artificial window and/or an artificial skylight device that includes a planar component to mimic a window frame, according to non-limiting examples.
FIG. 24 depicts a perspective front view of the device of FIG. 23 showing the mimicked window frame, according to non-limiting examples.
FIG. 25 depicts an artificial window and/or an artificial skylight device with an alternative illumination scheme, according to further non-limiting examples.
FIG. 26 depicts an artificial window and/or an artificial skylight device with yet a further alternative illumination scheme, according to further non-limiting examples.
FIG. 27 depicts an artificial window and/or an artificial skylight device with yet a further alternative illumination scheme, according to further non-limiting examples.

### DETAILED DESCRIPTION

Artificial windows and/or artificial skylights are becoming more popular, however such artificial windows and/or artificial skylights are generally large, bulky, and heavy, and hence can be challenging to hang on walls or ceilings. Furthermore, at least due the size, such artificial windows and/or artificial skylights may have significant cost. For example, to achieve a large artificial window and/or artificial skylight, such devices may generally rely on large flat panel displays (e.g., liquid crystal displays (LCD) greater than 25 cm across) and a depth of optics to provide light from such displays generally increase with width and height of such displays. Hence a "large" window may require a deep internal structure (e.g., due to long focal lengths of lenses thereof) which generally increases the weight, bulkiness (e.g., depth) and cost of such devices. Alternatively, such devices often rely on Rayleigh scattering to achieve a blue sky effect with one main illumination source illuminating a "sky" portion of the device and that also provides a sunlight effect, which can be ineffective at mimicking real life window and/or skylight images. Furthermore, to achieve desired brightness levels that may mimic a brightness of the sun shining through a window and/or skylight, a powerful illumination source may be required, a power of which may depend on a surface area of an artificial window and/or skylight, which may introduce commensurate cooling requirements and/or high prices.

As such, provided herein is a device that includes a collimating lens, a sheet having an image there at, the sheet being at least semitransparent, and at least one lamp behind the sheet that emits light that passes through the sheet, and which is collimated by the collimating lens. The image is generally located at a focal plane of the collimating lens, and which includes a focal point of the lens, and the focal plane may be flat or curved depending on given optical properties of the collimating lens. As such, the image is located at an optical "infinity" (e.g., and/or close to an optical infinity); hence, as a viewer who is viewing the image through the collimating lens moves their eyes and/or repositions themselves with respect to the device, and the like, the viewer will see a view of the image as if the viewer is viewing a scene at a great distance through a window or skylight.

The collimating lens may comprise a Fresnel and/or any other suitable collimating lens.

The sheet may be formed from any suitable material, including, but not limited to, vinyl, acrylic, polycarbonate, and the like. The sheet is understood to transmit at least a portion of the light from the at least one lamp and hence is at least semitransparent and/or translucent.

The image may be printed on the sheet and/or may comprise a separate material that is, for example, adhered to the sheet. The image is also understood to be at least semitransparent and/or translucent.

The image may be selected based on whether the device is used as an artificial window or artificial skylight.

For example, when the device is used as an artificial window, the image may include a sky portion, a ground portion and a horizon line, which may intersect the focal point of the collimating lens (though the horizon line may be at any suitable position) and which generally delineates between the sky portion and the ground portion. In some of these examples, the sky portion may be any suitable shade of blue (and/or any other suitable color and/or combination of colors and/or gradients of colors), and may include clouds and/or other features that may appear in the sky. The ground portion may be any suitable color and/or combination of colors, such as green, brown, blue (and/or any other suitable colors), and the like, and may include any suitable features that may appear through a window, such as trees, gardens, mountains, a city skyline, and the like. In some examples, features of the ground portion may extend into the sky portion. However, when the device is used as an artificial skylight, the image may include only a sky portion. The device is otherwise the same, and hence the device may be easily customized by changing the image and/or the sheet. In some examples, the image may be customized and/or changed after the device is manufactured and shipped.

The at least one lamp may comprise only one lamp, such as a light emitting diode (LED) and the like, arranged to provide light through a substantial portion and/or the entirety of the sheet, with any suitable optical devices arranged between the one lamp and the sheet. In other examples, the at least one lamp may comprise a plurality of lamps and/or an array of lamps, such as a plurality of LEDs and/or an array of LEDs, and the like which may, or may not be, provided with any suitable optical devices arranged between the one lamp and the sheet. The at least one lamp may be dimmable such that brightness of the at least one lamp may be controlled to mimic a time of day, and the like. Similarly, in some examples, a color temperature of the at least one lamp may be controllable such that the color temperature may be controlled to mimic a time of day, and the like. In examples where the at least one lamp is controllable, the device may comprise a controller, such as a microprocessor, and the like, which controls the at least one lamp.

In examples where the at least one lamp comprises a plurality of lamps and/or an array of lamps, one or more of the lamps may be controlled to a brightness and/or color temperature that mimics the sun relative to the other lamps which may be controlled to a brightness and/or color temperature that mimics the sky. In some of these examples, a portion of the lamps controllable to mimic the sun may be positioned along a line and/or an arc and controlled to respective brightnesses and/or color temperatures at different times to mimic the sun at different times of day at different positions in a sky portion of the image, for example to mimic passage of the sun in the sky. Put another way, to mimic passage of the sun in the sky, given lamps, of the portion of the lamps along the line and/or arc may be brightened one at a time, and others dimmed, for example in succession over eight to twelve hours, and the like (e.g., to mimic sunrise, passage of the sun across the sky, and sunset). When a given lamp that is controllable to mimic the sun, is not mimicking the sun, the given lamp may be controlled to a same brightness and/or color temperature as others of the lamps to mimic the sky. In some examples, the portion of the lamps controllable to mimic the sun may be of a different size and/or shape as others of the lamps, though in other examples, a portion of the lamps controllable to mimic the sun may be of a same size and/or shape as others of the lamps.

The device is generally understood to include a housing, and the like, which generally supports the collimating lens, the sheet and the at least one lamp. In some examples, the housing may include, but is not limited to, one or more mounting components for mounting the device (e.g., collimating lens, the sheet and the at least one lamp) on one or more of a wall and ceiling. Such mounting devices may include fasteners and/or adhesives and the like.

Furthermore, as the collimating lens, the sheet and the at least one lamp may be relatively small, for example, a width and height that may each be respectively less than 20 cm, the device may have a relatively smaller depth than larger prior art devices (e.g., due to smaller focal lengths of the collimating lens), rendering the device relatively lower in weight and less bulky than larger prior art devices, making the device easier to mount on a wall and/or ceiling. However, in other examples, the device may be mountable to a wall and/or ceiling using any suitable combination of mounting devices and/or fasteners external to the device.

However, such a small device may not be effective at mimicking a window and/or skylight by itself and/or may only mimic a smaller window and/or skylight. As such, the housing may include, but is not limited to, one or more tiling components for tiling the device with others of the plurality of devices, for example at a wall and/or ceiling. Such tiling components may include, but are not limited to, and suitable fasteners, magnets, and the like, and/or any component which assists at aligning edges of tiled devices. Such tiling components further include, but are not limited to: electrical connectors that electrically connect respective lamps in the tiled devices such that the tiled devices may be powered by a common power supply; and data connectors that connect the respective lamps and/or respective controllers in the tiled devices such that the tiled devices may be controlled by a common controller.

Put another way, a system may be provided that includes a plurality of the devices, with each of the plurality of the devices being substantially similar, for example with similar and/or same images at respective sheets, and similar and/or same arrays of lamps that are controlled in a similar manner. Each of the plurality of devices may include any suitable components which render the plurality of devices tileable and/or mountable adjacent to each other on a wall or ceiling. However, in other examples, the plurality of devices may be tileable using any suitable combination of tiling components and/or fasteners external to the device.

As the plurality of the devices may be substantially similar, and as respective images of the plurality of the devices may generally be the same, and located at respective optical infinities of respective lenses, a viewer who is viewing the respective images and respective light through the respective collimating lens, will generally view the respective images and respective light as one large image, as if the viewer is viewing a scene at a great distance through a window or skylight. However, due to the collimating lens collimating the light, the viewer will only view that portion of the large image at which the viewer is looking, at any given moment, in an optical illusion of the plurality of images of the tiled devices forming a larger image.

However, in practice, a presently provided plurality of the devices is unlikely to be often directly observed by a viewer, but rather such a plurality of the devices may provide lighting to a room which approximates and/or mimics lighting from a window or skylight. As such, total brightness and/or total illuminance of light emitted by the plurality of the devices may have peak intensities of greater than 30,000 nits (e.g., drastically brighter than flat panel displays of prior art devices); furthermore, a total intensity of particular lamps of the plurality of the devices which may be used to specifically mimic the sun, may have a total brightness and/or total illuminance greater than 1,000,000 nits, but which may be "concentrated" in regions of the plurality of devices where such lamps are located.

Furthermore, each of a plurality of such tiled devices may include smaller, lower power lamps, as compared to larger prior art devices that may have a surface area that is the same and/or similar to the plurality of such tiled devices. Put another way, comparing nine tiled devices provided herein to a larger monolithic prior art device that has a surface area that is nine times the size of a single tiled device, the larger monolithic device may require a lamp that is nine times the power of a respective lamp of a single tiled device, and such a lamp with nine times the power may be more expensive than the respective lamp of a single tiled device and/or may be more difficult to cool than the nine lamps of the nine tiled devices as provided herein. Hence, tiled devices as provided herein may be cheaper and easier to cool than a larger monolithic prior art device.

In this manner, an inexpensive, low weight artificial window and/or artificial skylight, with relatively cheaper and easier to cool, lower power lamps, may be provided which may be of any suitable size and/or shape, depending on a number of the devices tiled together, for example in an array. In particular, as each of the devices is of a relatively small size and low weight, mounting the devices individually to a wall or ceiling may generally enable ease of assembling a larger artificial window and/or artificial skylight. Furthermore, as the depth of the devices may be relatively smaller than prior art devices, such devices may generally occupy less space and/or be less obtrusive than prior art devices. Furthermore, manufacturing costs and shipping costs of such smaller devices may be reduced relative to larger, bulkier prior art devices.

Furthermore, the devices may be tiled in any suitable shape, not merely a rectangle and the like. For example, while an array of the devices may be arranged on a wall or ceiling with respective same numbers of the devices in rows and columns, the devices may be arranged in other shapes, such as a cross shape, irregular shapes, and the like.

In some examples, the housing may include a frame around an outside of the collimating lens to mimic a mullion of a window and/or skylight, such that when a plurality of devices are tiled, a mullioned artificial window and/or mullioned artificial skylight is provided. In other examples, the housing may not include a frame around an outside of the collimating lens such that the image viewed through the collimating lens extends to an edge of the device, such that an artificial window and/or skylight that is not mullioned is provided.

The device and/or plurality of devices may include, but is not limited to, any suitable combination of one or more power supplies to power the one or more lamps, for example one power supply per device, or one power supply for a system of a plurality of devices, which may be connected to a plurality of devices via the aforementioned tiling components. In some examples, the power levels per device may be within a range of Power over Ethernet (PoE) power levels and/or a PoE switch may be used supply power and communication connectivity to tiles on a per-port basis.

Similarly, the device and/or plurality of devices may include, but is not limited to, any suitable combination of one or more controllers for example to control the one or more lamps, for example one controller per device, or one controller for a system of a plurality of devices. When more than one controller is provided, the controllers may be in communication and/or may be synched to a common time, such that that control of the one or more lamps of the plurality of devices may be synchronized. Data connections may be provided between the plurality of devices via the aforementioned tiling components.

Other optional features of the device are described herein, including, but not limited to, one or more mirrors which may extend a viewing angle of the device and/or one or more curved and/or planar components extending from an edge of the collimating lens at least partially towards the focal point of the lens which may also mimic mullions of windows and/or skylights.

Other types of artificial windows and/or artificial skylights are provided herein.

For example, alternative devices may be provided that include a collimating lens, a sheet and an image similar to as described herein with respect to the devices that include at least one lamp behind the sheet. However, in contrast, such alternative devices may include, but are not limited to, at least one lamp arranged between the collimating lens and the sheet (e.g., and/or image), which illuminates the image; in these examples the sheet and/or image may not be transparent.

In further examples, other alternative devices may be provided that include a collimating lens, a sheet and an image similar to as described herein with respect to the devices that include at least one lamp behind the sheet. However, in contrast, such other alternative devices may include at least one lamp arranged at a surface of the sheet, for example at a position of a sun, which may also illuminate the image; in these examples the sheet and/or image may not be transparent.

In yet further examples, further alternative devices may include any suitable combination of lamps behind the sheet, between the collimating lens and the sheet, and at a surface of the sheet.

An aspect of the present specification provides a device comprising: a collimating lens having a focal plane and a focal point located in the focal plane, wherein the focal plane is flat or curved dependent on given optical properties of the collimating lens; a sheet having a lens-facing front side and a back side opposite the lens-facing front side, the sheet being semi-transparent and having an image thereat, at least at about the lens-facing front side, the image of the sheet located at about the focal plane of the collimating lens; and at least one lamp located at the back side of the sheet such that the sheet is between the collimating lens and the at least one lamp, the at least one lamp configured to emit light towards the back side of the sheet, at least a portion of the light transmitted through the sheet towards the collimating lens.

Another aspect of the present specification provides a system comprising: a plurality of devices, each of the plurality of devices comprising: a collimating lens having a focal plane and a focal point located in the focal plane, wherein the focal plane is flat or curved dependent on given optical properties of the collimating lens; a sheet having a lens-facing front side and a back side opposite the lens-facing front side, the sheet being semi-transparent and having an image thereat, at least at the lens-facing front side, the image of the sheet located at about the focal plane of the collimating lens; at least one lamp located at the back side of the sheet such that the sheet is between the collimating lens and the at least one lamp, the at least one lamp configured to emit light towards the back side of the sheet, at least a portion of the light transmitted through the sheet towards the collimating lens; and a housing comprising one or more of: one or more mounting components for mounting the collimating lens, the sheet and the at least one lamp on one or more of a wall and ceiling; and one or more tiling components for tiling the device with others of the plurality of devices.

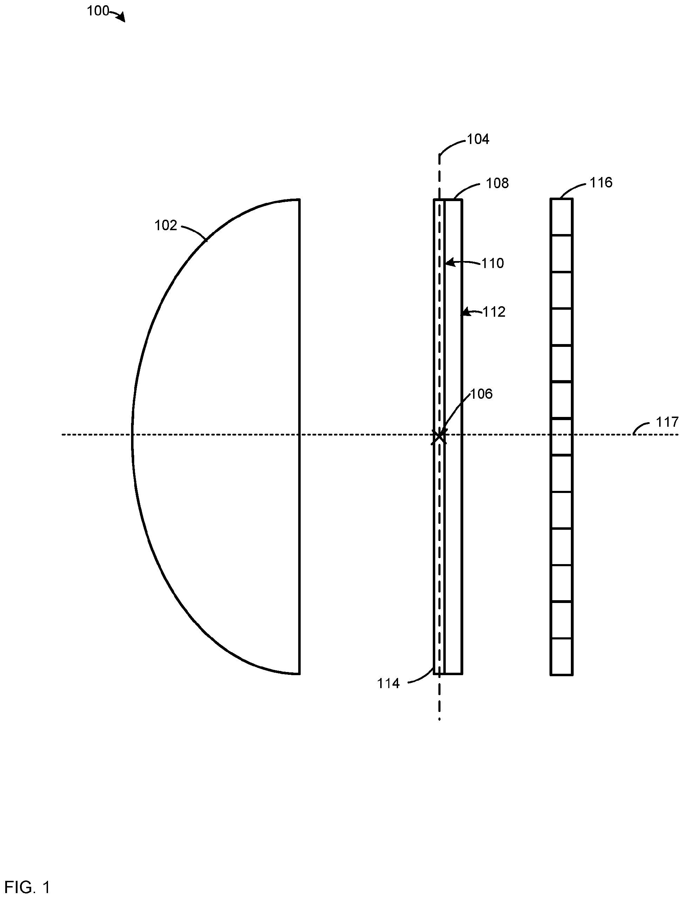

FIG. 1 depicts a schematic side view of a device 100 comprising: a collimating lens 102 having a focal plane 104 and a focal point 106 located in the focal plane 104, wherein the focal plane 104 is flat or curved dependent on given optical properties of the collimating lens 102; a sheet 108 having a lens-facing front side 110 and a back side 112 opposite the lens-facing front side 110, the sheet 108 being semitransparent, and/or translucent, and having an image 114 thereat, at least at the lens-facing front side 110, the image 114 on the sheet located at about the focal plane 104 of the collimating lens 102; and at least one lamp 116 located at the back side 112 of the sheet 108 such that the sheet 108 is between the collimating lens 102 and the at least one lamp 116, the at least one lamp 116 configured to emit light towards the back side 112 of the sheet, at least a portion of the light transmitted through the sheet 108 towards the collimating lens 102.

Details of the components of the device 100 are next described.

The collimating lens 102 may comprise any suitable collimating lens of any suitable shape and size, though in particular examples the collimating lens 102 may comprise a collimating Fresnel lens to minimize depth and weight of the device 100. However the collimating lens 102 may comprise any suitable collimating lens including, but not limited to, a spherical (or spherical) lens fabricated from any suitable optical material, such as any suitable type of optical glass and/or optical plastic. For simplicity, the collimating lens 102 is interchangeably referred to hereafter as the lens 102.

Furthermore, while as depicted, the lens 102 may comprise a single collimating lens, in other examples the lens 102 may comprise any suitable number of collimating lenses 102, though a number of lenses 102 may be generally selected according to given dimensions of the device 100, for example to ensure the device 100 is small and light, relative to prior art devices. Indeed, in particular examples, the lens 102 may be specifically limited to a single lens of dimensions similar to a height and width of the device 100. Put another way, in some examples the device 100 may comprise only one lens 102.

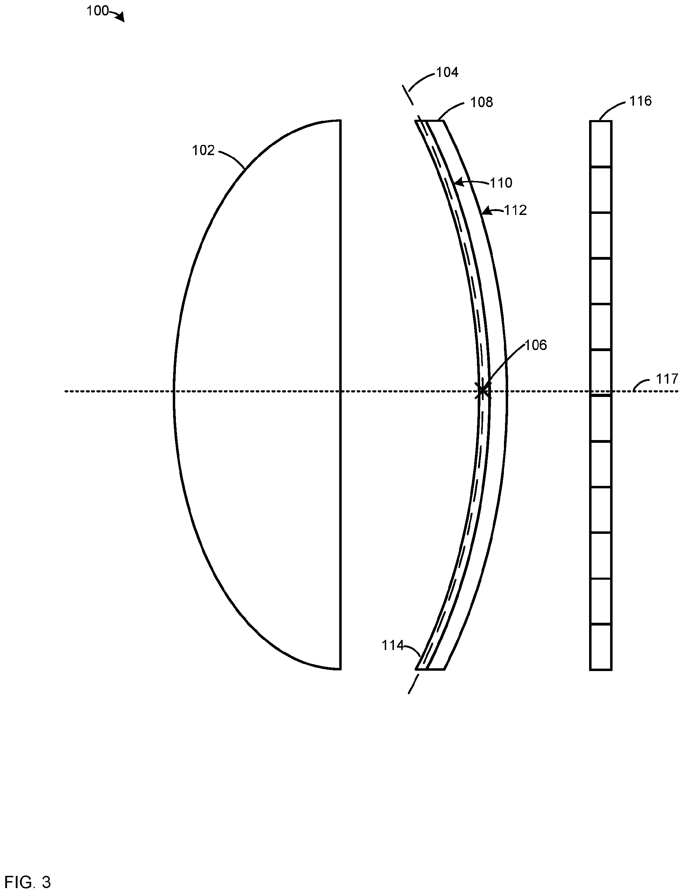

In general, the lens 102 is understood to have given optical properties which define a focal plane 104 of the lens 102 and a focal point 106 of the lens 102. In FIG. 1, and throughout, the focal plane 104 is depicted in dashed lines and the focal point 106 is depicted as an "x" with the focal point 106 understood to be at a center of the "x". In general, the focal point 106 is understood to be located along a center axis 117 of the lens 102, and at a focal length of the lens 102. Furthermore, the center axis 117 is understood to be normal to lens 102, and extending through a center of the lens 102 and the focal point 106. The center axis 117 is further understood to be normal to the focal plane 104 (e.g., and the sheet 108 and the image 114). In general, to minimize depth of the device 100, the focal point 106 of the lens 102 is selected to be as small as possible, though this may result in use of a lens that has some degree of optical distortions and/or aberrations, which may result in the focal plane 104 being curved, described in more detail below with respect to FIG. 3. However, the focal plane 104 being curved may also be due to any other optical properties of the lens 102.

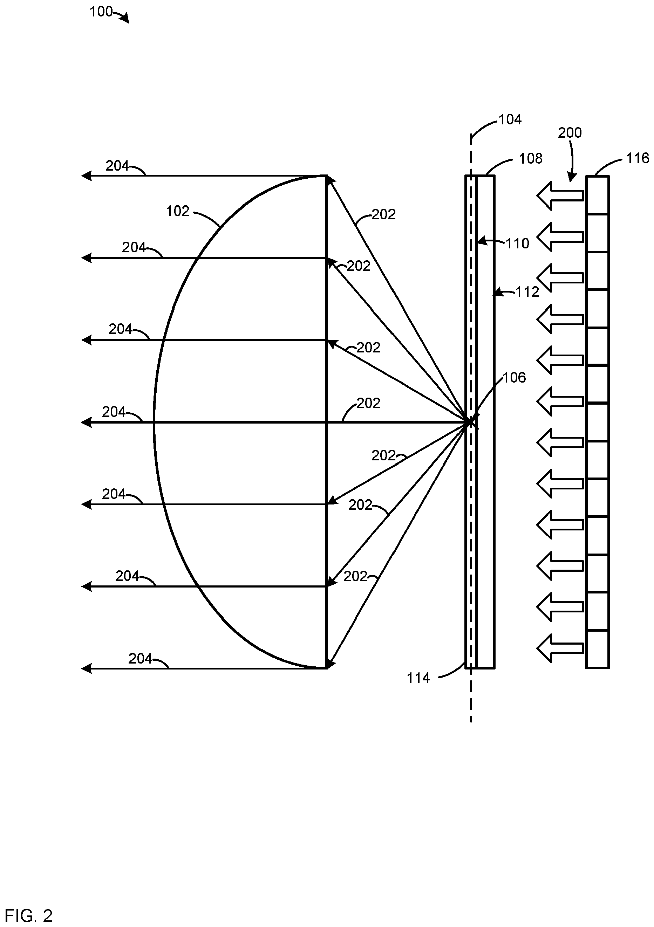

With reference to FIG. 2, which is substantially similar to FIG. 1, with like components having like numbers (though the center axis 117 is omitted for clarity), but which depicts paths of light through the device 100, it is understood that light 200 from at least one lamp 116 is transmitted through the sheet 108 and the image 114. It is furthermore understood that transmitted light 202 travelling from the focal point 106 and/or the focal plane 104 towards the lens 102 is generally collimated by the lens 102 to produce collimated light 204, such that any image located at (and/or near and/or adjacent to) the focal point 106 and/or the focal plane 104, such as the image 114, is formed at (and/or near and/or adjacent to) an optical infinity when viewed by a viewer. Hereafter, while the image 114 may be described as being located at the focal plane 104 of the collimating lens 102 and/or at an optical infinity, it is understood that the image 114 may be located at about the focal plane 104 of the collimating lens 102 and/or at about an optical infinity. Indeed, optical effects described herein may occur when the image 114 is located at the focal plane 104 of the collimating lens 102 and/or when the image 114 is located at about the focal plane 104 of the collimating lens 102 (e.g., within a few millimeters of the focal plane 104 and/or within 10%, within 5%, within 1%", within 0.5%", amongst other possibilities, from the focal plane 104, relative to a distance between a back side and/or an image facing side of the lens 102 and the focal plane 104 and/or relative to a focal length of the lens 102)

As such, the image 114 is understood to be located at the focal plane 104 and intersects the focal point 106 so that, for a viewer, the image 114 is formed at an optical infinity.

It is understood that while the light 202, 204 is drawn in specific locations as rays of the light 202, 204, the light 202, 204 is generally continuous and a size of the sheet 108 and the image 114 is selected with respect to the lens 102 such that when the image 114 is viewed through the lens 102 a viewer views an extent of the image 114 but without viewing edges thereof (e.g., dimension of the sheet 108 and the image 114 may be similar to, or larger than dimension of an image facing side of the lens 102).

However, the lens 102 may not be a perfect lens and/or may include optical distortions and/or aberrations, and/or given optical properties, and the like, which may result in the focal plane 104 being flat or curved depending on the given optical properties. As such, when the focal plane 104 is flat, the sheet 108 (e.g., and the image 114) is flat, however when the focal plane 104 is curved according to given optical properties of the lens 102, the sheet 108 (e.g., and the image 114) is curved.

For example, attention is directed to FIG. 3, which is substantially similar to FIG. 1, with like components having like numbers, however FIG. 3 depicts a top view of the device 100 in which the focal plane 104 is curved horizontally (e.g., left to right), and hence the sheet 108, and the image 114 are similarly curved. It is understood in these examples, comparing FIG. 1 and FIG. 3, that the device 100, including the lens 102, the sheet 108, and the image 114 (e.g., as well as an array of lamps 116, described in more detail below) are generally rectangularly shaped, with a width of the device 100 being larger than a height of the device 100.

In particular, as depicted, and again comparing FIG. 1 and FIG. 3, it is understood that in these examples, the focal plane 104, the sheet 108 and the image 114 are curved in the horizontal direction (e.g., along a width of the device 100), but not in a vertical direction (e.g., not along a height of the device 100). Such curvature may be dependent on given optical properties of the lens 102, which may be due to the lens 102 being rectangular (e.g., and/or the lens 102 comprising a rectangular Fresnel lens) and/or the lens 102 having given optical distortions and/or aberrations. However, in some examples the focal plane 104, the sheet 108 and the image 114 may be curved in both the horizontal and vertical directions, dependent on given optical properties of the lens 102. It is understood, however, that while the device 100 is described as being oriented in a particular direction (e.g., FIG. 1 is described as a side view and FIG. 3 is described as top view), the device 100 may be oriented in any suitable direction (e.g., the device 100 may be rotated by 90° such that FIG. 1 may alternatively be described as a top view and FIG. 3 may be described as side view, with the image 114 oriented accordingly).

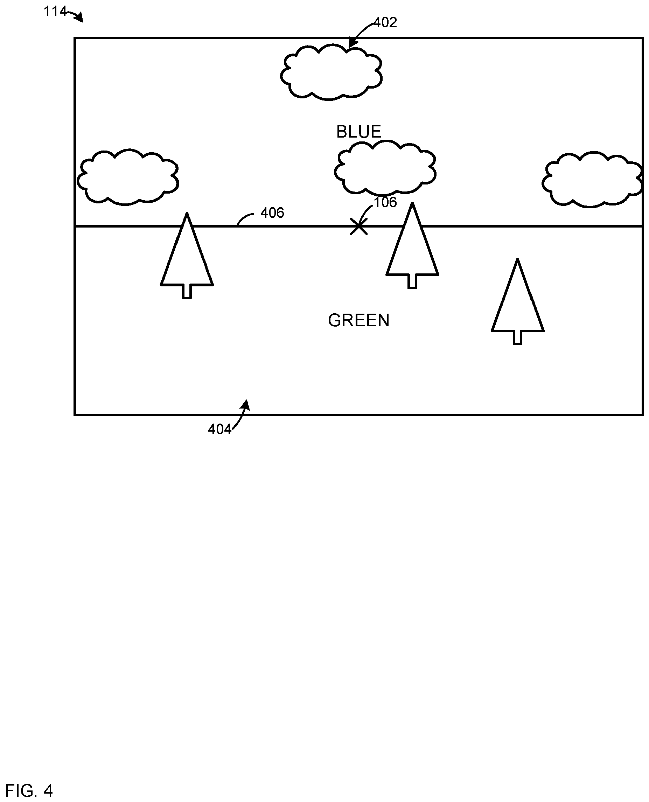

Regardless, the sheet 108, and hence the image 114, are generally shaped to conform with the focal plane 104 of the lens 102 such that, to a viewer, the image 114 appears flat and/or, to a viewer at least a horizon line of the image 114 may appear flat and/or straight and/or not curved (e.g., as described below with respect to FIG. 4).

Put another way, the sheet 108 and the image 114 may be flat or curved according to one or more of the focal plane 104 and the given optical properties of the collimating lens 102.

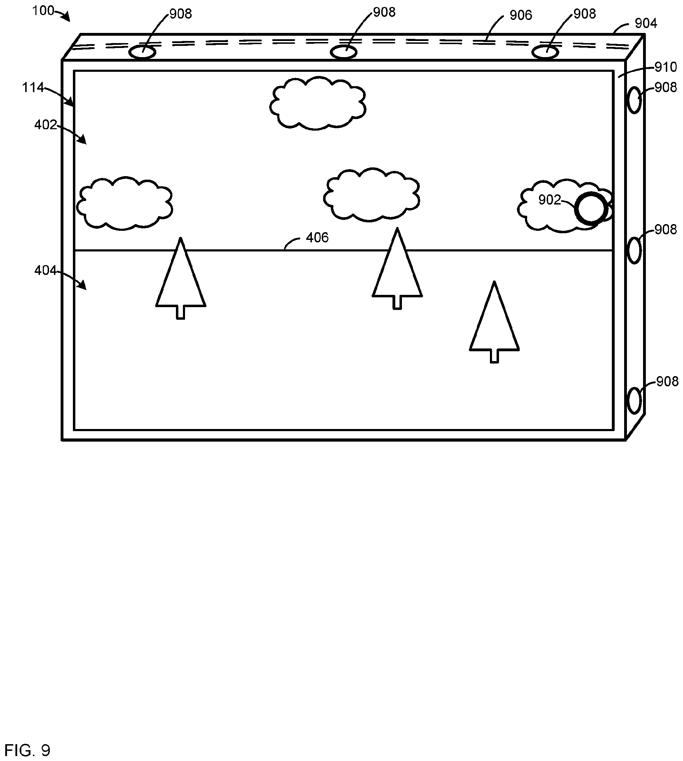

The sheet 108 may be formed from any suitable materials which are partially transparent and which may be at least partially rigid to maintain a given shape thereof, however the sheet 108 may be bendable, for example into a curve, to conform to a curve of the focal plane 104; such a curve may be maintained by the sheet 108 being supported by a housing of the device 100 (e.g., see FIG. 9). The sheet 108 may be formed from any suitable material, including, but not limited to, vinyl, acrylic, polycarbonate, and the like, that is at least semitransparent and/or translucent. However, the sheet 108 may alternatively be formed from glass, and the like
Regardless, of material, the sheet 108 and the image 114 are understood to transmit at least a portion of light 200 from the at least one lamp 116 and hence the sheet 108 and the image 114 are understood to be at least semitransparent and/or translucent.

The image 114 may be printed on the sheet and/or may comprise a separate material (e.g., including, but not limited to, vinyl, acrylic, polycarbonate, and the like) that is adhered to the sheet 108. However, the image 114 may be formed in any suitable manner. When the image 114 is formed on a separate material from the sheet 108 and adhered to a sheet 108 that is bendable, it is understood that the material of the sheet 108 may also be bendable to conform to a curved sheet 108, though such bending and/or curving may occur after the image 114 is adhered to (and/or printed on), the sheet 108.

With reference to FIG. 1, FIG. 2 and/or FIG. 3, while the image 114 is depicted as having some depth, with the focal plane 104 bisecting the image 114, and a center of the image 114 about located at the focal point 106 of the collimating lens 102, it is understood that the image 114 may be printed on the lens-facing front side 110 of the sheet 108 and hence the focal plane 104 and the focal point 106 may be substantially co-located at a surface of the lens-facing front side 110 and/or the focal plane 104 and the focal point 106 may be substantially defined by the surface of the lens-facing front side 110.

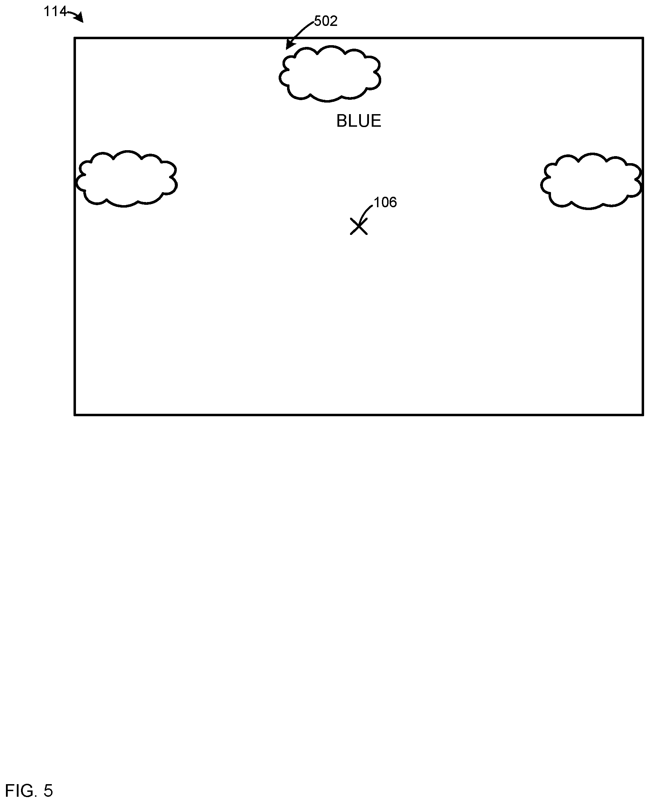

Examples of the image 114 are next described with respect to FIG. 4 and FIG. 5 which respectively depict a front view of an image 114 that may be used when the device 100 is configured as an artificial window, and a front view of an image 114 that may be used when the device 100 is configured as an artificial skylight.

With attention directed to FIG. 4, in these examples of an image 114 for an artificial window, the image 114 may comprise a sky portion 402, a ground portion 404 and a horizon line 406, for example which intersects the focal point 106 of the collimating lens 102 (though the horizon line 406 may be at any suitable position) and which delineates between the sky portion 402 and the ground portion 404. In some of these examples, the sky portion 402 may be any suitable shade of blue, and is hence labelled "Blue" in FIG. 4 for clarity only (e.g., the word "Blue" does not generally appear in the sky portion 402), and may include (e.g., as depicted) clouds and/or other features that may appear in the sky.

The ground portion 404 may be any suitable color and/or combination of colors, such as green, brown, and the like, and is hence labelled "Green" for clarity only in FIG. 4 (e.g., the word "Green" does not generally appear in the ground portion 404), and may include any suitable features that may appear through a window, such as trees (e.g., as depicted), gardens, mountains, a city skyline, and the like. In some examples, features of the ground portion 404 may extend into the sky portion 402; for example, as depicted two trees extend from the ground portion 404 into the sky portion 402. However, the image 114 may include any suitable image that may correspond to imagery viewable through a window, and may be customized depending on given aesthetics, given regions, and the like.

However, it is understood that while blue and green are depicted, the sky portion 402 and the ground portion 404 may be any suitable colors and/or combination of colors and/or shades of colors and/or gradients of colors, and the like, and furthermore, while alphanumeric text is generally omitted from the sky portion 402 and the ground portion 404, in other examples, alphanumeric text may be present at the sky portion 402 and/or the ground portion 404 (e.g., in the form of an image of a billboard and/or advertising and/or skywriting, and the like).

While the image 114 of FIG. 4 has a particular orientation, with the horizon line 406 extends across a long dimension of the rectangular image 114, in other examples the image 114 may have another orientation depending on whether the device 100 is to be mounted to a wall with a long dimension being horizontal or vertical, or another orientation. For example, when the device 100 is to be mounted to a wall vertically, the horizon line 406 may extend across a short dimension of the image 114, with the sky portion 402 and the ground portion 404 adapted accordingly. Furthermore, the curvature of the focal plane 104, the sheet 108 and the image 114 may be selected such that, to a viewer, the horizon line 406 appears flat and/or straight and/or not curved, and the like.

In contrast, and with attention directed to FIG. 5, in these examples of an image 114 for an artificial skylight, the image 114 may comprise a sky portion 502 (e.g., and no ground portion and no horizon line). In some of these examples, the sky portion 502 may be any suitable shade of blue (e.g., and/or any other suitable color and/or combinations of colors and/or shades of colors and/or gradients of colors, and the like), and is hence labelled "Blue" in FIG. 5 for clarity only (e.g., the word "Blue" does not generally appear in the sky portion 502, though alphanumeric text may appear in the sky portion 502), and may include (e.g., as depicted) clouds and/or other features that may appear in the sky. However, the image 114 may include any suitable image that may correspond to imagery viewable through a sky, and may be customized depending on given aesthetics, given regions, and the like. In these examples the orientation of the image 114 may be suitable for the device 100 being mounted to a ceiling in any suitable orientation.

The at least one lamp 116 may comprise any suitable type of lamp, however in particular examples, the at least one lamp 116 may comprise at least one light emitting diode (LED). In some examples, brightness and color temperature of the at least one lamp 116 may be fixed, such that when the device 100 is on, the device 100 emits the collimating light 204 that does not change in brightness and color temperature. However, in other examples, brightness and color temperature of the at least one lamp 116 may be controllable, as described in more detail below, such that brightness and color temperature of the collimating light 204 may be controlled.

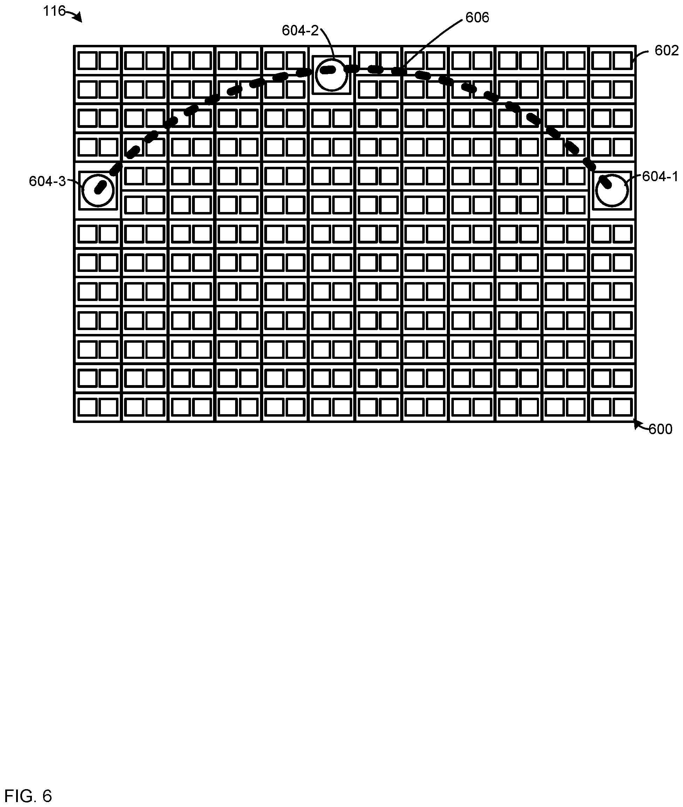

With attention next directed to FIG. 6, which depicts a front view of the at least one lamp 116, as depicted, the at least one lamp 116 may comprise an array 600 of lamps 116, such as LEDs, which substantially uniformly illuminate the back side 112 of the sheet 108 such that the image 114 is substantially uniformly illuminated from the back side 112. For example, the array 600 of lamps 116 may be of a same and/or similar size (height and width) as the sheet 108. Put another way, the at least one lamp 116 may comprise an array 600 of lamps 116 configured to illuminate the image 114 about uniformly, and the array 600 may have any suitable size and/or shape and may be smaller, the same or similar, or larger than the sheet 108.

As depicted, the array 600 of lamps 116 include two types of lamps 116: smaller lamps 602 that are arranged in the array 600; and larger lamps 604-1, 604-2, 604-3 that are arranged along a line and/or arc 606 in the array 600. For simplicity, the larger lamps 604-1, 604-2, 604-3 are interchangeably referred to hereafter, collectively, as the lamps 604 and, generically, as a lamp 604. This convention will be used elsewhere in the present specification. While only one smaller lamp 602 is indicated for simplicity, it is understood that that the array 600 comprises a plurality of the smaller lamps 602 arranged, for example, in 13 rows and 12 columns.

As depicted, each smaller lamp 602 includes two LEDs per smaller lamp 602 as represented by two squares per smaller lamp 602. In some of these examples, each of the two LEDs may be a same and/or similar color temperature, however in other examples, each of the two LEDs may be a different color temperature, for example to enable more flexibility and/or control of color temperature of the smaller lamps 602.

Furthermore, while three larger lamps 604 are depicted, the device 100 may include only smaller lamps 602 (e.g., no larger lamps 604 which may be replaced by smaller lamps 602), one larger lamp 604, two larger lamps 604, or more than three larger lamps 604 (e.g., arranged along the line and/or arc 606 in the array 600). Furthermore, while the terms smaller and larger are used to distinguish between the lamps 602, 604 as depicted in FIG. 6, the lamps 602, 604 may be of any suitable size and/or shape relative to each other, and hence may be a same size and/or the lamps 604 may be smaller than the lamps 602. Hence, the lamps 602, 604 may alternatively be respectively referred as a first lamps 602 and a second lamps 604.

The smaller lamps 602 may be used for general illumination of the image 114, while the larger lamps 604 may be used both for general illumination and to mimic passage of the sun across a sky portion 402, 502 of the image 114. As such, the larger lamps 604 are circular in shape, but may be of any suitable shape and/or size.

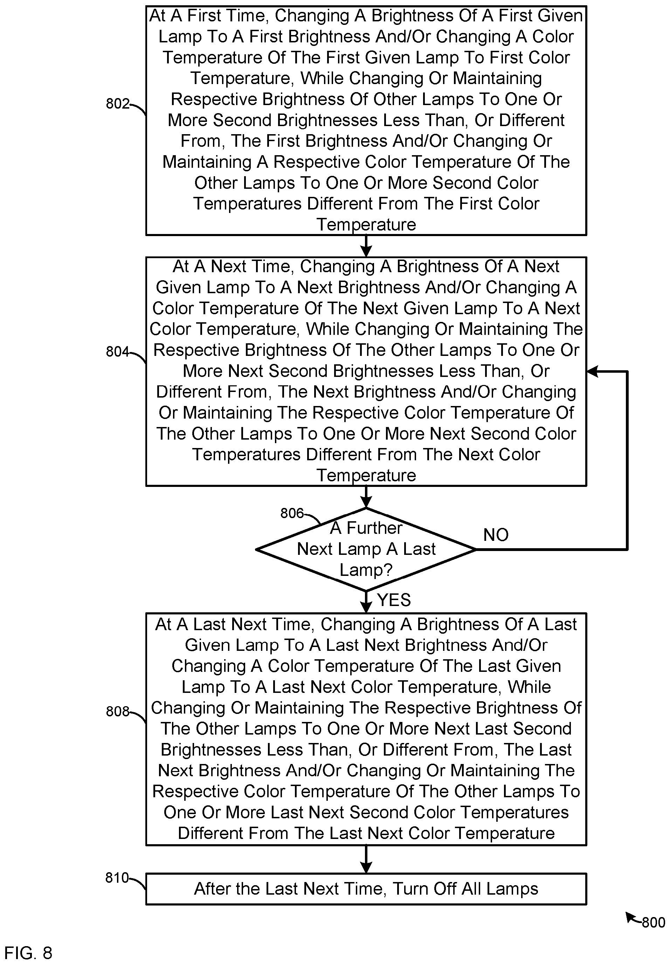

For example, the arc 606 may represent a path of the sun across a sky portion 402, 502 of the image 114, and the larger lamps 604 may be brightened or dimmed at different times, relative to each other and the smaller lamps 602, to mimic passage of the sun across a sky portion 402, 502. Color temperature of the smaller lamps 602 and/or the larger lamps 604 may also be controlled at different times to represent different times of day, such as sunrise, noon and sunset and/or any other suitable time of day. Control of the lamps 602, 604 will be discussed in more detail with respect to FIG. 8, FIG. 9, FIG. 10, and FIG. 11.

Alternatively, the at least one lamp 116 may comprise as few as one lamp 116 configured to substantially uniformly illuminate the image 114 from the back side 112 of the sheet 108. In some of these examples, the at least one lamp 116 may comprise any suitable optical components to facilitate such substantially uniformly illumination, such as a Fresnel lens, a light scattering sheet, and the like. Indeed, in some examples, the at least one lamp 116 comprise a light scattering sheet which emits the light 200 towards the sheet 108 when illuminated from an edge by one or more LEDs, and the like.

Regardless, is understood that, as depicted in FIG. 1, FIG. 2 and FIG. 3, the sheet 108 and the image 114 are between the lens 102 and the at least one lamp 116 and/or the sheet 108 and the image 114 are between the lens 102 and a light source of any suitable size and shape.

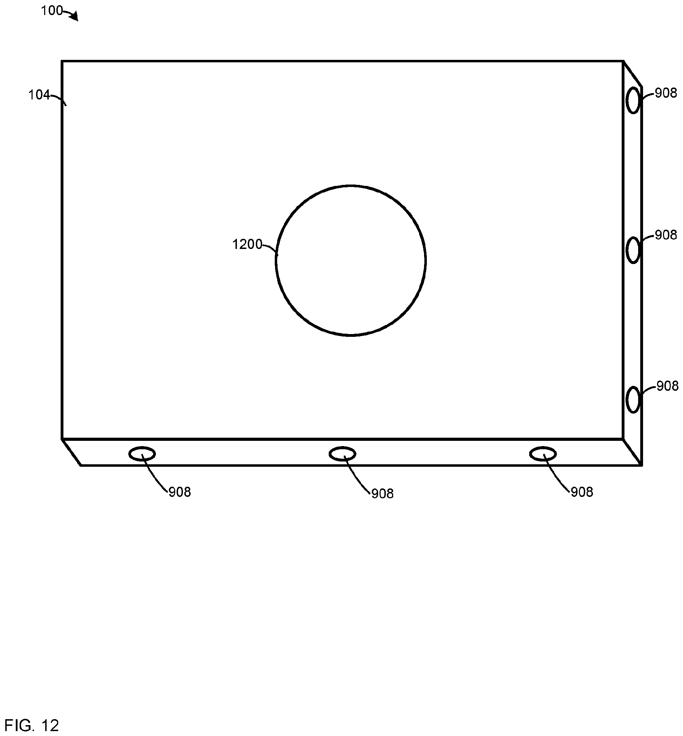

In general, optical properties and/or a type of the lens 102, the focal point 106 of the lens 102, and spacing between the at least one lamp 116 and the sheet 108 and/or spacing between the sheet 108 and the at least one lamp 116 may be selected to minimize a depth of the device 100. The depth of the device 100 may be understood to include a distance from the front of the lens 102 (e.g., an external side of the lens 102 that faces away from the sheet 108 and/or the image 114 and/or the at least one lamp 116) to a back side of the at least one lamp 116 (e.g., a side of the at least one lamp 116 that faces away from the sheet 108) and/or a back side of a housing of the device 100, described in more detail with respect to FIG. 12. Similarly, components of the device 100 may be selected to minimize weight of the device 100. For example, the lens 102 may comprise a Fresnel lens made of optical plastic which is lighter than other types of lenses and/or other types of materials. Similarly, the sheet 108 may be formed from a plastic, and the like, rather than glass.

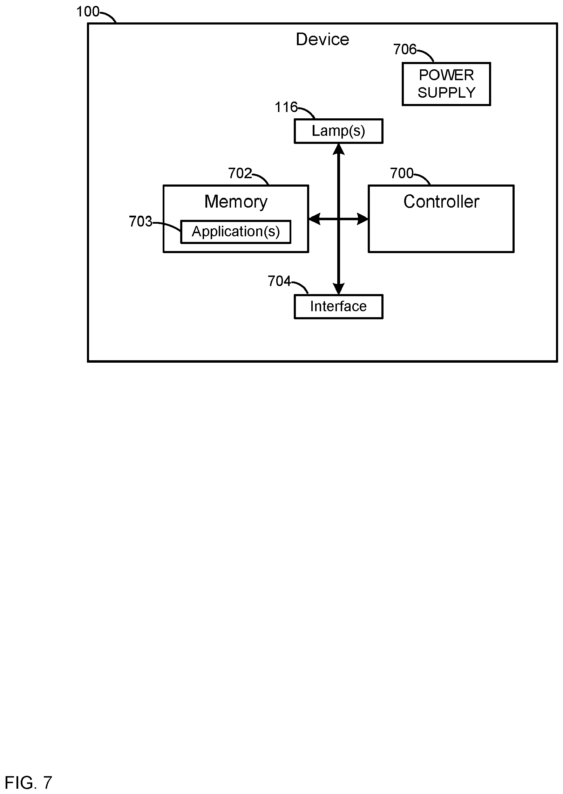

Electronic components of the device 100 are now described with respect to FIG. 7. In particular, electronic components of the device 100 may generally comprise: the one or more lamps 116; a controller 700; a memory 702 storing one or more applications 703; and optionally a communication interface 704 (interchangeably referred to hereafter as the interface 704). The device 100 may further comprise a power supply 706. The controller 700 is understood to be communicatively connected with the at least one lamp 116 and the memory 702 and, when present the interface 704.

The controller 700 can comprise a processor and/or a plurality of processors, including but not limited to one or more central processors (CPUs) and/or one or more graphics processing units (GPUs) and/or one or more processing units; either way, the controller 700 comprises a hardware element and/or a hardware processor. In some implementations, the controller 700 can comprise an ASIC (application-specific integrated circuit) and/or an FPGA (field-programmable gate array), and/or Raspberry Pi^{™} and/or Arduino^{™} type devices, specifically configured to control brightness and/or color temperature of the at least one lamp 116 and/or respective brightness and/or color temperature of the at least one lamp 116 of the array 600. Hence, the device 100 may preferably not be a generic computing device, but a device specifically configured to implement specific functionality for controlling brightness and/or color temperature of the at least one lamp 116. For example, the device 100 and/or the controller 700 can specifically comprise a computer executable engine configured to implement functionality for controlling brightness and/or color temperature of the at least one lamp 116.

The memory 702 can comprise a non-volatile storage unit (e.g., Erasable Electronic Programmable Read Only Memory ("EEPROM"), Flash Memory) and a volatile storage unit (e.g., random-access memory ("RAM")). Programming instructions that implement the functional teachings of the device 100 as described herein are typically maintained, persistently, in the memory 702 and used by the controller 700 which makes appropriate utilization of volatile storage during the execution of such programming instructions. Those skilled in the art recognize that the memory 702 is an example of computer readable media that can store programming instructions executable on the controller 700. Furthermore, the memory 702 is also an example of a memory unit and/or memory module and/or a non-volatile memory.

In particular, the memory 702 stores the application 703 that, when processed by the controller 700, enables the controller 700 and/or the device 100 to implement blocks of a method described with reference to FIG. 8.

The interface 704, when present, may comprises any suitable wired or wireless communication interface configured to communicate with other devices 100 and/or an external controller. The interface 704 may communicate in a wired and/or wireless manner as desired including, but not limited using cables, Wi-Fi communication links, Bluetooth^{™} communication links, personal area networks, local area networks, and the like. In some examples, the interface 704 may include a wired power interface to receive power from an external power supply and/or the provide power from the power supply 706 to other devices 100.

The power supply 706 may comprise any suitable power supply, including, but not limited to, a power supply that connects to a mains power supply and adapts power from the mains power supply to power the other electronic components of the device 100, such as the one or more lamps 116, the controller 700 and the interface 704. In some examples, the power supply 706 may comprise a PoE power supply, and the like. However, in other examples, the power supply 706 may comprise a battery, and the like.

However, in other examples, the device 100 may not comprise the controller 700, the memory 702 and/or the power supply 706, but may be controlled and/or powered from an external controller and/or an external power supply, for example of another device 100 that includes the configuration depicted in FIG. 7. Data and/or power connections between such devices 100 may occur via the interface 704 and/or tiling components described herein.

Indeed, in examples where a plurality of devices 100 are tiled, one of the devices 100 may act as a primary device 100 which controls its respective at least one lamp 116, and others of the plurality of devices 100 may act a secondary devices 100 which are controlled by the primary device 100, with electronic components of the plurality of devices 100 adapted accordingly. However, all of the electronic components of the plurality of devices 100 may be similar and/or the same, with one of the plurality of devices 100 set as a primary device 100 (e.g., an electronic setting, a switch, and the like, and/or which may be configurable via an external computing device and/or communication device, such as a mobile phone operating an application for configuring the plurality of devices 100, which communicates the plurality of devices 100 via one or more respective interfaces 704). Regardless, control of the plurality of devices 100 may be synchronized in any suitable manner such that respective lamps 116 of the plurality of devices 100 behave in a similar manner at similar times. Indeed, in some examples, such synchronization may occur by synchronizing respective clocks of the plurality of devices 100, such as clocks of respective controllers 700 and/or processors thereof.

Attention is now directed to FIG. 8 which depicts a flowchart of a method 800 for controlling at least one lamp 116 of the device 100. The operations of the method 800 may correspond to machine readable instructions that are executed by the device 100, and specifically the controller 700 of the device 100. In the illustrated example, the instructions represented by the blocks of FIG. 8 are stored at the memory 702 for example, as the application 703. The method 800 of FIG. 8 is one way in which the controller 700 and/or the device 100 may be configured. Furthermore, the following discussion of the method 800 of FIG. 8 will lead to a further understanding of the device 100, and its various components.

The method 800 of FIG. 8 need not be performed in the exact sequence as shown and likewise various blocks may be performed in parallel rather than in sequence. Accordingly, the elements of method 800 are referred to herein as "blocks" rather than "steps." The method 800 of FIG. 8 may be implemented on variations of the device 100.

Furthermore, while the method 800 is described with respect to three larger lamps 604, as depicted in FIG. 4, the method 800 may be applied to any suitable number of larger lamps 604.

Furthermore, the method 800 may be specifically implemented for lamps 116 arranged along a line or arc, such as the larger lamps 604 arranged along the line or arc 606.

At a block 802, the controller 700 and/or the device 100, at a first time, changes a brightness of a first given lamp 116 (e.g., the first lamp 604-1 arranged along the line or arc 606) to a first brightness and/or changes a color temperature of the first given lamp 116 to a first color temperature. As depicted, at the first time, the controller 700 and/or the device 100 also changes or maintains a respective brightness of other lamps 116 to one or more second brightnesses less than (and/or different than) the first brightness and/or changes or maintains a respective color temperature of the other lamps 116 to one or more second color temperatures different from the first color temperature.

For example, at a first time that may correspond to a sunrise time (e.g., and which may or may not correspond to a time of an actual sunrise), the controller 700 and/or the device 100 may control the first larger lamp 604-1 to a brightness and/or color temperature for mimicking brightness and/or color temperature of the sun at sunrise.

The specific color temperature may depend on the location of the first larger lamp 604-1 relative to the image 114. For example, the first larger lamp 604-1 may be located behind a "Blue" area of a sky portion 402, 502 of the image 114, or the first larger lamp 604-1 may be located behind a cloud of the image 114, which may be white. When the first larger lamp 604-1 is located behind a "Blue" area of a sky portion 402, 502 of the image 114, the color temperature of the first larger lamp 604-1 may be adjusted to compensate for the blue portion giving the transmitted light 202 a blue color. For example, the color temperature of the first larger lamp 604-1 may be controlled to a color temperature that that represents any suitable combination of green and red (e.g., green and red wavelengths) such that the emitted light 200, when transmitted through the blue of the image 114, produces white, yellow, red or orange transmitted light 202 and/or white, yellow, red or orange collimated light 204. Alternatively, when the first larger lamp 604-1 is located behind a cloud of a sky portion 402, 502 of the image 114, and the cloud is white, the color temperature of the first larger lamp 604-1 may be controlled to a white, yellow, red or orange color temperature, such that the emitted light 200, when transmitted through the white of the image 114, produces white, yellow, red or orange transmitted light 202 and/or white, yellow, red or orange collimated light 204. Regardless, in some examples, lamps 602, 604 may be selected with as high a color rendering index (CRI) as is possible to ensure that "realistic" renderings of features of the image 114 are viewed by a viewer.

In contrast, the other lamps 116, such as the smaller lamps 602 and the other larger lamps 604 (e.g., the other larger lamps 604-2, 604-3, 604-4), may be changed to one or more respective brightnesses and/or color temperatures different from that of the first larger lamp 604-1, for example to mimic brightness and/or color temperature of the sky, clouds, etc. at sunrise, with color temperatures selected according to a color of the image 114 through which respective emitted light 200 is being transmitted, for example to achieve specific color temperatures of respective transmitted light 202 and/or respective collimated light 204. Color temperature of the other lamps 116 may be selected to be correspond to any suitable white color temperature, or any suitable shade and/or shades of red and/or orange and/or yellow. However, when the other lamps 116 are already at such respective brightnesses and/or color temperatures, such respective brightnesses and/or color temperatures may be maintained.

In this manner, the image 114 may appear to a viewer as if the sun is rising at the location of the first larger lamp 604-1.

Indeed, before the first time, all of the lamps 116 may be off and the lamps 116 may be controlled to any suitable respective brightnesses and/or respective color temperatures to mimic sunrise. Furthermore, it is understood that the respective brightnesses and/or respective color temperatures of the lamps 116 may change over time from respective brightnesses and/or respective color temperatures that represent sunrise to respective brightnesses and/or respective color temperatures that represent morning times later than sunrise.

At a block 804, the controller 700 and/or the device 100, at a next time, increases a brightness of a next given lamp 116 (e.g., the second lamp 604-2 arranged along the line or arc 606) to a next brightness and/or changes a color temperature of the next given lamp 116 to a next color temperature. As depicted, at the next time, the controller 700 and/or the device 100 also changes or maintains a respective brightness of other lamps 116 to one or more second brightnesses less than (and/or different from) the next brightness and/or changes or maintains a respective color temperature of the other lamps 116 to one or more second color temperatures different from the next color temperature.

For example, the next time of the block 804 may comprise a time after the first time of the block 802 and may correspond to any suitable time that corresponds to any time between a sunrise time and a sunset time, such as noon (e.g., and which may or may not correspond to an actual noon time).

For example, a brightness and/or color temperature of the second larger lamp 604-2 may be respectively changed to a next brightness and/or a next color temperature, which may be the same or different as a brightness and color temperature to which the first larger lamp 604-1 has been controlled prior to the next time of the block 804. Such a next brightness and/or a next color temperature may represent the sun at noon, and/or any other suitable time.

Regardless, it is understood that, at the next time, the first larger lamp 604-1, as well as the other lamps 116, are controlled to respective next second brightnesses and/or a respective next color temperatures that are respectively different from the next brightness and next color temperature of the second larger lamp 604-2, and which represents the sky at noon, and/or any other suitable time, in contrast to the next brightness and/or the next color temperature of the second larger lamp 604-2 that represents the sun.

It is further understood that the respective changes to the first larger lamp 604-1 and the second larger lamp 604-2 may be "graceful" and/or occur over a given time period that includes the next time, such as 1 minute, 5 minutes, 30 minutes, amongst other possibilities. For example, the brightness of the second larger lamp 604-2 may increase and/or change over a given time period while the respective brightness of the first larger lamp 604-1 may decrease and/or change over the given time period. Similarly, the color temperature of the second larger lamp 604-2 may change over a given time period while the respective color temperature of the first larger lamp 604-1 may change over the given time period. Indeed, any changes to the other lamps 116 may also be graceful occur over the given time period.

Furthermore, respective brightnesses and/or color temperatures of the lamps 116 may change over time representing brightnesses and/or color temperatures of the sun and the sky over the course of an afternoon.

At a block 806, the controller 700 and/or the device 100 determines whether a further next lamp 116 (e.g., (arranged along the line or arc 606) is a last lamp 116 arranged along the line and/or the arc 606. For example, a further next lamp 116 may comprise the last larger lamp 602-3.

When the further next lamp 116 is not a last lamp 116 (e.g., there are more than three larger lamps 604 and hence "NO" decision is determined at the block 806), the block 804 is repeated such that a further next lamp 116 arranged along the line and/or the arc 606 is controlled to a respective brightness and/or color temperature that corresponds to the sun yet a further next time, while other lamps 116 are controlled to a respective brightness and/or color temperature that corresponds to the sky at the further next time.

For example, a further next time may correspond to a time in the mid-afternoon or evening (e.g., and/or between noon and sunset).

Hence, the block 806 is repeated (and changes to brightnesses and/or color temperatures of lamps 116 may occur gracefully as described heretofore) until the second last lamp 116 along the line or the arc 606 is controlled at the block 806, and when the further next lamp 116 is a last lamp 116 (e.g., the last larger lamp 602-3), and a "YES" decision occurs at the block 806, at a block 808, the controller 700 and/or the device 100, at a last next time, changes a brightness of a last given lamp 116 to a last next brightness and/or changes a color temperature of the last given lamp 116 to a last next color temperature, while changing or maintaining the respective brightness of the other lamps 116 to one or more next last second brightnesses less than, or different from, the last next brightness and/or changing or maintaining the respective color temperature of the other lamps to one or more last next second color temperatures different from the last next color temperature.

For example, the last next time may comprise a time that corresponds to sunset, and a brightness and/or color temperature of the last larger lamp 604-3 may be respectively changed to a last next brightness and/or a last next color temperature, which may be the same or different as a brightness and color temperature to which the second larger lamp 604-2 has been controlled prior to the last next time. Such a last next brightness and/or a last next color temperature may represent the sun at sunset. Similarly, the other lamps 116, such as the smaller lamps 602 and the other larger lamps 604-1, 604-2, may be controlled to respective brightnesses/or color temperatures that correspond to the sky at sunset.

At an optional block 810, the controller 700 and/or the device 100 may turn off all the lamps at a time after the last next time of the block 808, for example at a time corresponding to a night time. The method 800 may repeat at a next day (e.g., and/or at any suitable time corresponding to a next day and/or at any suitable given time).

Put another way, the device 100 may comprise the controller 700 and the at least one lamp 116 may comprises a plurality of lamps 116 at different respective locations relative to the sheet 108 (e.g., the larger lamps 604 arranged along the line or arc 606) and the controller 700 may be configured to respectively brighten and dim individual lamps 116 of the plurality of lamps 116 according to one or more of a time of day, one or more given brightness levels and one or more given color temperatures.

Put yet another way, the device 100 may comprise the controller 700 and the at least one lamp 116 may comprises a plurality of lamps 604 arranged at different respective locations along a line or arc 606 relative to one or more of the sheet 108 and the horizon line 406 of the image 114 (e.g., see FIG. 9, FIG. 10 and FIG. 11), the plurality of lamps 604 including a first lamp 604-1 and a last lamp 604-3 located at opposite ends of the line or the arc 606 (e.g., as depicted in FIG. 6), and the controller 700 may be configured to: at respective times of day brighten a respective lamp 604 in succession along the line or arc 606, starting with the first lamp first lamp 604-1 and ending with the last lamp first lamp 604-3, and dim any other lamps 604 of the plurality of lamps when a given lamp 604 is brightened.

In some of these examples, the at least one lamp 116 may further comprise the array 600 of smaller lamps 602 in addition to the plurality of lamps 604 arranged along the line or arc 606, and the controller 700 may be further configured to: maintain a respective brightness of the array 600 of lamps 602 while given lamps 604 of the plurality of lamps 604 are being brightened or dimmed; and when the any other lamps 604 of the plurality of lamps are being dimmed, dim the any other lamps 604 to the respective brightness of the array 600 of lamps 602. Hence, larger lamps 604 that are not mimicking the sun at a given time are controlled to a same and/or similar brightness level as the smaller lamps 602. Similarly, the larger lamps 604 that are not mimicking the sun at a given time may controlled to a same and/or similar color temperature as the smaller lamps 602; indeed, in some examples, color temperature of the smaller lamps 602 may not be controllable and/or may be fixed, and in other examples, color temperature of the smaller lamps 602 may be controllable; regardless, the larger lamps 604 that are not mimicking the sun at a given time may controlled to a same and/or similar color temperature as the smaller lamps 602.

In some examples, aspects of the method 800 may be implemented via a lookup table (LUT) stored, for example, at the memory 702. Such a lookup table may store settings for each of the lamps 602, 604 and/or for groups of the lamps 602, 604, and furthermore such settings in such a LUT may be associated with given times and/or relative times. For example, assuming there are three times at which the brightness and/or color temperature of the lamps 602, 604 may change, a first group of settings may be associated with a first time (e.g., of the block 802, and/or which may control the lamps 602, 604 to brightnesses and/or color temperatures associated with "Sunrise"), a second group of settings may be associated with a second time (e.g., a next time of the block 804 and/or which may control the lamps 602, 604 to brightnesses and/or color temperatures associated with "Noon"), and a third group of settings may be associated with a third time (e.g., a last next time of the block 808, and/or which may control the lamps 602, 604 to brightnesses and/or color temperatures associated with "Sunset"), and at each of the first, second and third times, the lamps 602, 604 may be controlled via corresponding first, second and third groups of settings of the LUT. In some examples where changes to the lamps 602, 604 occur at more than three times, for example at times between the first, second and third times, the LUT may still store only three groups of settings for the lamps 602, 604, and the controller 700 may interpolate for settings at the times between the first, second and third times based on the settings associated with the first, second and third times. For example, over the course of a given time period that begins and ends with the first and third times, at any given time between the first and second time, the controller 700 may determine corresponding settings between the first and second settings by interpolating therebetween using, for example, a time dependent linear interpolation and/or a time dependent interpolation using any suitable type of function (e.g., parabolic, and the like).

Alternatively, the settings to which the lamps 602, 604 are controlled may be user selective. In particular, using a mobile phone (and the like) operating an application for configuring a device 100, and/or a plurality of devices 100, a user may select a group of settings stored in a LUT to control the lamps 602, 604 to the selected group of settings. Hence, for example, a user may select (e.g., in the application) between "Sunrise", "Noon", and "Sunset" and a device 100, and/or a plurality of devices 100 may be controlled accordingly with associated settings stored in the LUT.

Similarly, in other examples, a user may select, (e.g., in the application) a time between "Sunrise" and "Noon", or a time between "Noon" and "Sunset" and a device 100, and/or a plurality of devices 100 may be controlled accordingly by interpolating between associated settings stored in the LUT.

Indeed, while the LUT has been described with respect to three groups of settings, such a LUT may store as few as one group or two groups of settings, or such a LUT may store more than three groups of settings.

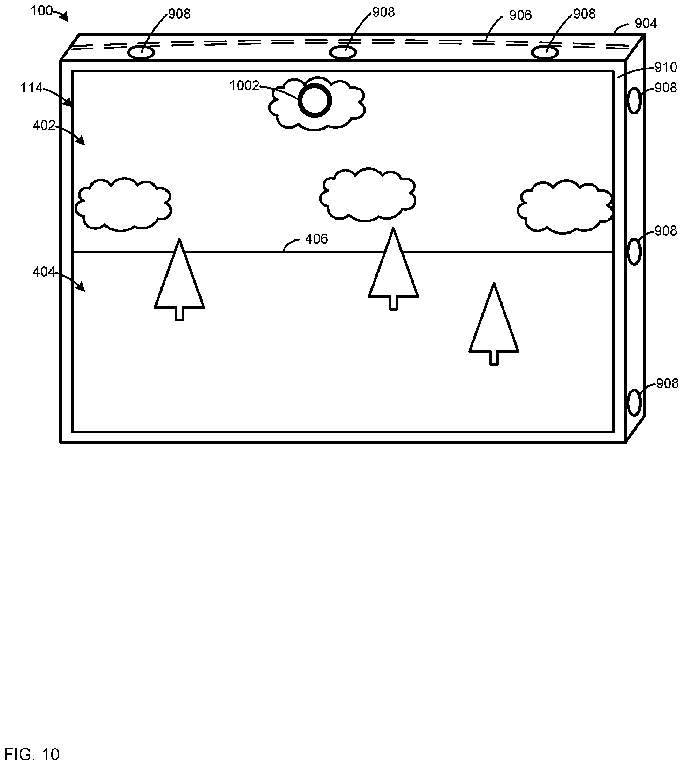

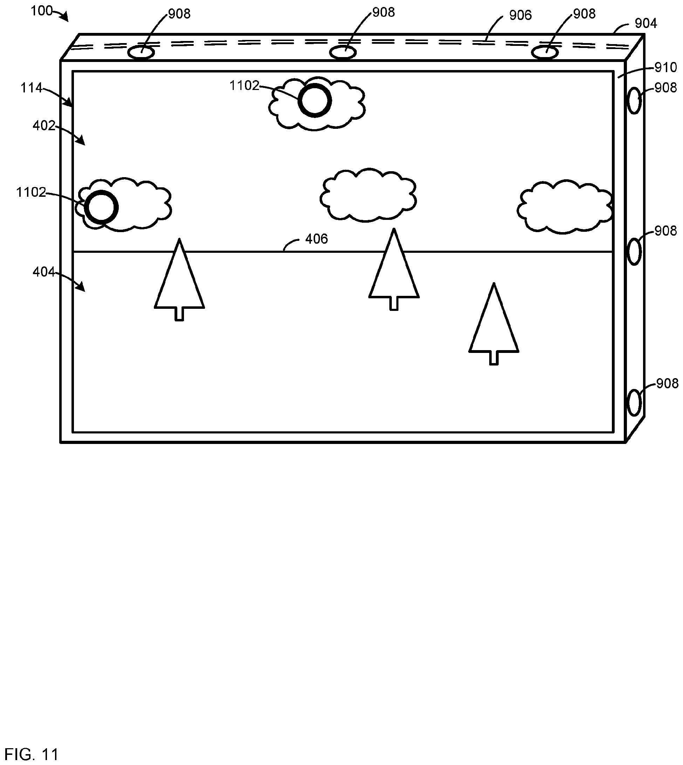

Attention is next directed to FIG. 9, FIG 10 and FIG. 11, which depict perspective front views of the device 100 configured as an artificial window. Hence, the image 114 comprises the sky portion 402, the ground portion 404, and the horizon line 406. FIG. 9, FIG 10 and FIG. 11 further depict an example of the method 800. In particular, FIG. 9 depicts the device 100 with the lamps 602, 604 controlled according to the block 802, FIG. 10 depicts the device 100 with the lamps 602, 604 controlled according to the block 804, and FIG. 11 depicts the device 100 with the lamps 602, 604 controlled according to the block 808.

Comparing FIG. 9 and FIG. 6, it is apparent that the first larger lamp 604-1 is being controlled to be brighter than the remaining lamps 602, 604, and that the first larger lamp 604-1 is emitting collimated light 204 through a region 902 of the image 114, which may correspond to a position of the sun around (e.g., and/or just after) sunrise, and the like. While as depicted the region 902 also corresponds to a position of a cloud in the sky portion 402, the region 902 may include any suitable features and/or may be blue. Regardless, the device 100 as depicted in FIG. 9 may represent the device 100 at times corresponding to sunrise and/or a morning.

FIG. 9 (and FIG. 10 and FIG. 11) further depicts a housing 904, an internal groove 906 of the housing 904, tiling components 908 and a front frame 910, described in more detail below.

Next comparing FIG. 10 and FIG. 6, it is apparent that the second larger lamp 604-2 is being controlled to be brighter than the remaining lamps 602, 604, and that the second larger lamp 604-3 is emitting collimated light 204 through a region 1002 of the image 114, which may correspond to a position of the sun around noon, and the like. While as depicted the region 1002 also corresponds to a position of another cloud in the sky portion 402, the region 1002 may include any suitable features and/or may be blue, and the like. Regardless, the device 100 as depicted in FIG. 10 may represent the device 100 at times corresponding to noon and/or afternoon, and is understood to follow in time from FIG. 9.

Next comparing FIG. 11 and FIG. 6, it is apparent that the third larger lamp 604-3 is being controlled to be brighter than the remaining lamps 602, 604, and that the third larger lamp 604-3 is emitting collimated light 204 through a region 1102 of the image 114, which may correspond to a position of the sun around sunset, and the like. While as depicted the region 1102 also corresponds to a position of another cloud in the sky portion 402, the region 1102 may include any suitable features and/or may be blue, and the like. Regardless, the device 100 as depicted in FIG. 11 may represent the device 100 at times corresponding to sunset, and is understood to follow in time from FIG. 10. It is understood, however, that the positions of the larger lamps 604-1, 604-3 may not strictly correspond to a respective position of the sun around sunrise and sunset (e.g., as sunrise and sunset may not viewable via a single window and/or skylight in real life), but nonetheless such positions may respectively represent sunrise and sunset. Indeed, to more effectively mimic sunrise and sunset, a system may be provided that includes devices 100 on opposite and/or respective walls, which may be respectively controlled to represent sunrise and sunset (e.g., an east wall and a west wall).

Regardless, FIG. 9, FIG. 10, and FIG. 11 are understood to represent the device 100 at different successive times of a day, and further indicate that the larger lamps 604 may be arranged relative to the horizon line 406 representing different positions of the sun in the sky (e.g., along the arc 606). Put another way, FIG. 9 depicts the device 100 with an artificial sun in a first position, FIG. 10 depicts the device 100 with the artificial sun in a second position, and FIG. 11 depicts the device 100 with the artificial sun in a third position.

Furthermore, color temperature of the larger lamps 604 may also be controlled in the examples of FIG. 9, FIG. 10, and FIG. 11, and similarly brightness and/or color temperature of the smaller lamps 602 may also be controlled in the examples of FIG. 9, FIG. 10, and FIG. 11. Furthermore, transitions between the states of the device 100 depicted in the examples of FIG. 9, FIG. 10, and FIG. 11 may occur gracefully over a given time period.

While the examples of FIG. 9, FIG. 10 and FIG. 11 are described with respect to the image 114 as depicted in FIG. 4, the device 100 may be similarly operated when the image 114 of FIG. 5 is incorporated therein, however, a location of the "sun" is not restricted to being "above" the horizon line 406 as the entirety of the image 114 of FIG. 5 is sky portion 502.

Furthermore, in other examples, the lamps 116 of the array 600 may be operated without specifically mimicking the sun. In these examples, the larger lamps 604 may be replaced with the smaller lamps 602. In particular, in some of these examples, all of lamps 116, of the at least one lamps 116, may be controlled to achieve similar brightness and/or similar color temperature to mimic changes in brightness and/or color temperature throughout a day, but without specifically controlling any of the lamps 116 to mimic the sun. For example, at a time corresponding to sunrise, brightness of the lamps 116 may increase and/or turn on (e.g., gracefully and/or over a given time period), and color temperature of the lamps 116 may change to mimic sunrise. The brightness and/or color temperature of the lamps 116 may change throughout times corresponding to a "day", to mimic different times of day. And, at a time corresponding to sunset, brightness of the lamps 116 may decrease and/or turn off (e.g., gracefully and/or over a given time period), and color temperature of the lamps 116 may change to mimic sunset.

Furthermore, in some examples, brightness and/or color temperature of the lamps 116 at any given time may be controlled to different brightness and/or color temperatures, for example such that combinations of color, and/or gradients of color, and/or shades of color occur at the device 100. Put another way, the lamps 116 may be controlled by region and/or individually to generate any suitable visual effect at the device 100.

Returning now to FIG. 9, the device 100 is understood to further comprise the housing 904 that supports the collimating lens 102, the sheet 108 (e.g., and the image 114) and the at least one lamp 116). An internal groove 906 of the housing is depicted in dashed lines at an internal "top" side of the housing 904 to represent that the groove 906 is internal to housing 904; while not depicted a similar opposing internal groove may be located at an opposing internal "bottom" side of the housing 904. It is understood that the groove 906 (and the opposing internal groove) may support the sheet 108 and the image 114. In some examples, the top or bottom of the housing 904 may include an aperture in the shape of a slot into which the sheet 108 and the image 114 may be inserted, to facilitate customization and/or changing of the sheet 108 and/or the image 114. Such a slot may be covered by a door and/or panel and the like, which may be opened and/or removed, and closed and/or reattached, to facilitate changing of the sheet 108 and/or the image 114.

The one or more tiling components 908 are generally configured for tiling the device 100 with other devices 100 similar to the device 100. For example, one or more tiling components 908 may be arranged along external sides of the housing 904 (e.g., sides perpendicular to a front side where the lens 102 is located) and may comprise magnets, fasteners, and the like, which fasten and/or connect to respective tiling components 908 of other devices 100.

For example, with further reference to FIG. 9 and FIG. 12, which depicts another perspective view of the device 100 showing a back side and a bottom side of the device 100, at which tiling components 908 may also be arranged, at a top side of the housing 904 (as depicted in FIG. 9), the tiling components 908 may comprise magnets of given polarities, and at the bottom side of the housing 904 (as depicted in FIG. 12), the tiling components 908 may comprise magnets of respective given polarities opposite to the given polarities of the corresponding magnets of the top side. Similarly, at a right side of the housing 904 (as depicted in FIG. 9), the tiling components 908 may comprise magnets of given polarities, and at the left side of the housing 904 (as depicted in FIG. 12), the tiling components 908 may comprise magnets of respective given polarities opposite to the given polarities of the corresponding magnets of the right side. The magnets may be positioned such that, when the device 100 is placed next to another device 100 with a same arrangement of magnets, the magnets attract each other, and position the devices 100 such that respective sides of their respective housing 904 are aligned. However, such magnets are merely one example of tiling components 908 and any other suitable tiling components 908 are within the scope of the present specification, including, but not limited to, any suitable combination of mechanical fasteners, locating pins, hook and loop fasteners, adhesive fasteners, and the like.

Furthermore, one or more of the tiling components 908 may be adapted for power and/or data connectivity, and hence one or more of the tiling components may comprise a male plug, and the like, which connect with a respective female plug, and the like, of tiling components 908 of other devices 100. Put another way, one or more of the tiling components 908 may comprise a power connector and/or data connector that connects to a respective power connector and/or respective data connector of another device 100. Indeed, a given device 100 may have such a respective connector on a top side, a bottom side, a left side and right side of the housing 904 such that power and/or data connections may occur regardless of whether another device 100 is located at top side, a bottom side, a left side and right side of the housing 904 when tiled. However power, and the like, may be distributed to the devices 100 in any suitable manner, including, but not limited to, squid cables, and the like.

While twelve tiling components 908 are depicted, any suitable number of tiling components 908 are within the scope of the present specification.

FIG. 12 further depicts an example of one or more mounting components 1200 which, as depicted, may be located at a back side of the housing 904, at a side opposite the lens 102. While only one mounting component 1200 is depicted, any suitable number of mounting components 1200 are within the scope of the present specification. The one or more mounting components 1200 may comprise any suitable number of mounting components for mounting device 100 (e.g., the collimating lens 102, the sheet 108, the image 114 and the at least one lamp 116) on one or more of a wall and ceiling. For example, the one or more mounting components may comprise mechanical fasteners, hook and loop fasteners, adhesive fasteners, and the like.

Hence, the housing 904 is understood to comprise one or more of: one or more mounting components 1200 for mounting the device 100 (e.g., the collimating lens 102, the sheet 108, the image 114 and the at least one lamp 116) on one or more of a wall and ceiling; and one or more tiling components 908 for tiling the device 100 with others of a plurality of devices 100. Put another way, the housing 904 may comprise the one or more mounting components 1200 and the one or more tiling components 908, or the housing 904 may comprise the one or more mounting components 1200 or the one or more tiling components 908, or the housing 904 may not comprise the one or more mounting components 1200 and the one or more tiling components 908. Hence, mounting components and/or tiling components may be part of the device 100 and the housing 904, or mounting components and/or tiling components may be external to the device 100 and the housing 904.

Again with reference to FIG. 9, the housing 904 is understood to comprise a front frame 910 which, as depicted, may surround the image 114 as viewed through the lens 102. The front frame 910 may further support the lens 102. The front frame 910 may aesthetically correspond to a mullion of an artificial window and/or artificial skylight, and the feature of the front frame 910 may be customized to achieve certain aesthetics. For example, the front frame 910 may be shaped and/or colored according to customized shapes and/or colors suitable for different types of rooms, and the like. Furthermore, it is understood that the front frame 910 may be optional, with the lens 102 supported by sides (e.g., top, bottom, left and right sides) of the housing 904, such that when tiling devices 100, no mullions are formed in a larger artificial window and/or skylight formed by a plurality of the devices 100 as tiled.

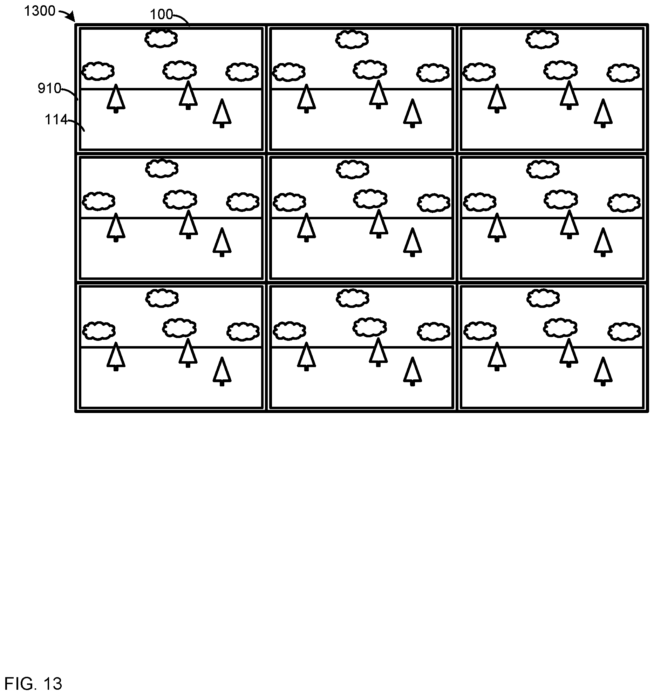

Attention is next directed to FIG. 13 which depicts a system 1300 of a plurality of the devices 100 tiled together, for example, in an array of three by three devices 100 (e.g., nine devices 100), however only one of the nine devices 100 and a respective image 114 and a respective frame 910 is the indicated for simplicity.

It is furthermore understood that each of the devices 100 is depicted as if a viewer were looking directly at each one individually, merely to show that each of the devices 100 has a same image 114 that corresponds to an artificial window (e.g., as depicted in FIG. 4).

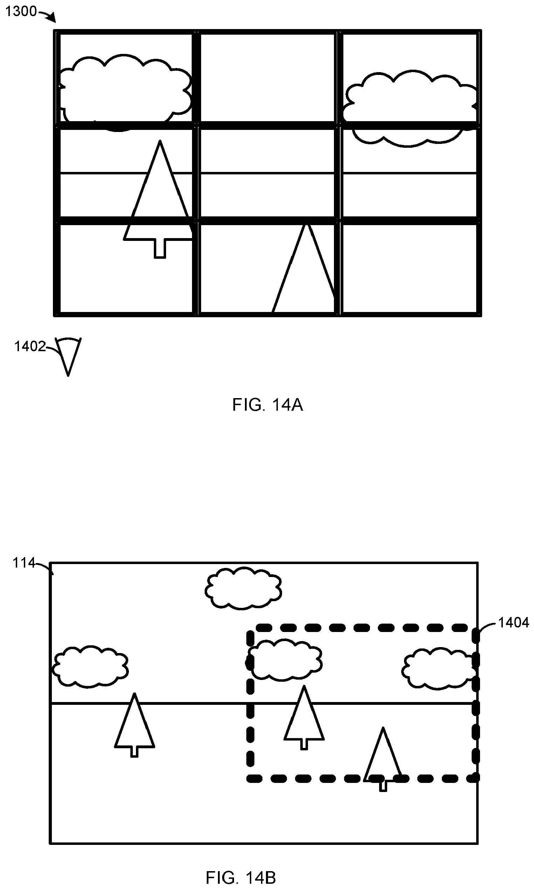

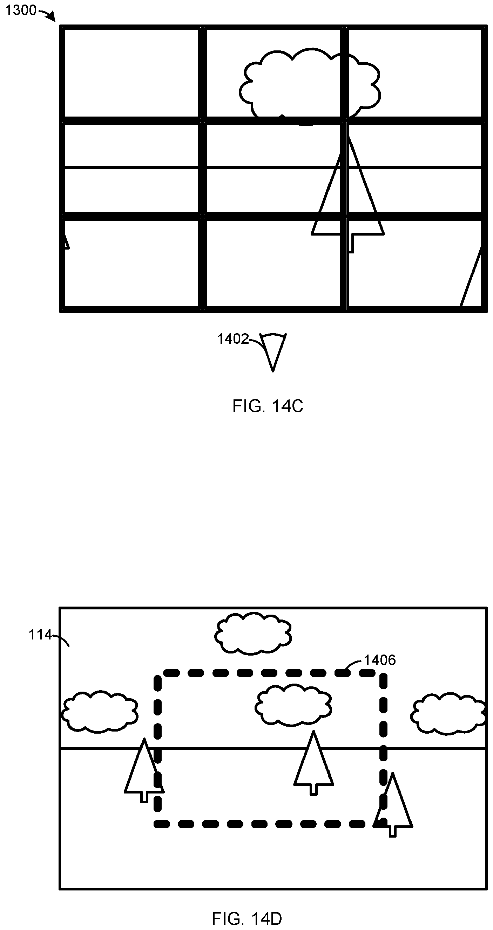

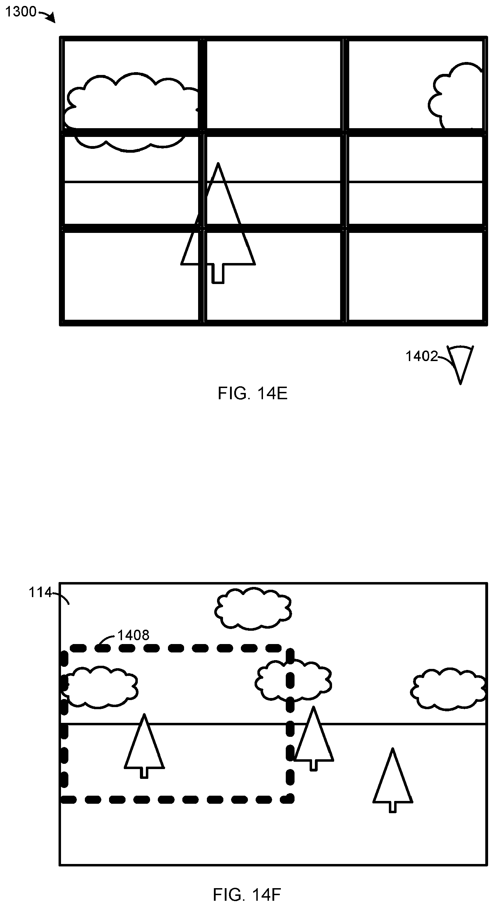

However, attention is next directed to FIG. 14A, FIG. 14B, FIG. 14C, FIG. 14D, FIG. 14E and FIG. 14F which illustrate what viewer 1402 may view at the devices 100 when tiled together, for example as the system 1300. In particular, FIG. 14A, FIG. 14C, and FIG. 14E depict the system 1300 with the viewer 1402, respectively, viewing the system 1300 at a left side, middle and right hand side of the system 1300. While for simplicity the viewer 1402 is depicted below the system 1300, it is understood that in the examples described herein, the viewer 1402 is located about at vertical middle of the system 1300. As will be further described, FIG. 14A, FIG. 14C, and FIG. 14E further depict what the viewer 1402 views at the system 1300 at the respective positions, due to an optical effect that is due to the collimation of the collimated light 204 by the lens 102, and the respective images 114 of each of the devices 100 of the system 1300 appearing at about an optical infinity. In particular, it is understood that, in the examples described herein, the viewer 1402 is positioned relative to the system 1300 such that the viewer 1402 is viewing a portion of any given image 114 at one device 100 of the system 1300 at any given time, though it is understood that the closer the viewer 1402 to the system 1300 (and/or a device 100), the larger a field of view of what the viewer 1402 is viewing at the devices 100 of the system 1300. Regardless, due to the respective images 114 of each of the devices 100 of the system 1300 appearing at about an optical infinity, the viewer 1402 views respective portions of the collective images 114 of the devices 100 of the system 1300 as if they were a portion of a single image 114.

For example, FIG. 14B, FIG. 14D, and FIG. 14F respectively depict the image 114, and respective portions 1404, 1406, 1408 of the image 114 that the viewer 1402 views at the system 1300 due the aforementioned optical effect, for example at a particular position relative to the system 1300.

In particular, with reference to FIG. 14A and FIG. 14B, with the viewer 1402 located at a left side of the system 1300, the viewer 1402 views a right portion of the image 114 indicated by the portion 1404, similar to what the viewer 1402 might see when looking out a window from a left side of such a window. For example, when a human being (e.g., the viewer 1402) is located at a left side of a real world window, the viewer 1402 tends to view objects that are relatively located to a right side of the window. The system 1300 behaves in a similar manner as illustrated by FIG. 14A and FIG. 14B.

Similarly, with reference to FIG. 14C and FIG. 14D, with the viewer 1402 located at a middle of the system 1300, the viewer 1402 views a middle portion of the image 114 indicated by the portion 1406, similar to what the viewer 1402 might see when looking out a window from a middle of such a window. For example, when a human being (e.g., the viewer 1402) is located at a middle of a real world window, the viewer 1402 tends to view objects that are relatively located at a center of the window. The system 1300 behaves in a similar manner as illustrated by FIG. 14C and FIG. 14D.

Similarly, with reference to FIG. 14E and FIG. 14F, with the viewer 1402 located at a right side of the system 1300, the viewer 1402 views a left portion of the image 114 indicated by the portion 1408, similar to what the viewer 1402 might see when looking out a window from a right side of such a window. For example, when a human being (e.g., the viewer 1402) is located at a right side of a real world window, the viewer 1402 tends to view objects that are relatively located at a left side of the window. The system 1300 behaves in a similar manner as illustrated by FIG. 14E and FIG. 14F..

While not depicted, it is further understood that if the viewer 1402 were to view the system 1300 from above or below the middle of the system 1300, the horizon line 406 (and the like) as visible in the tiled array of the devices 100, would appear to track to the real horizon, and/or the optical effect would be similar to as depicted in FIG. 14A, FIG. 14B, FIG. 14C, FIG. 14D, FIG. 14E and FIG. 14F. For example, when the viewer 1402 is viewing the system 1300 from "above" the viewer 1402 will view a bottom portion of the image 114, and similarly, when the viewer 1402 is viewing the system 1300 from "below" the viewer 1402 will view a top portion of the image 114.

Regardless of from where the viewer 1402 is viewing the system 1300, collimated light 204 from all of the devices 100 contribute to the overall brightness and/or illuminance of the system 1300.

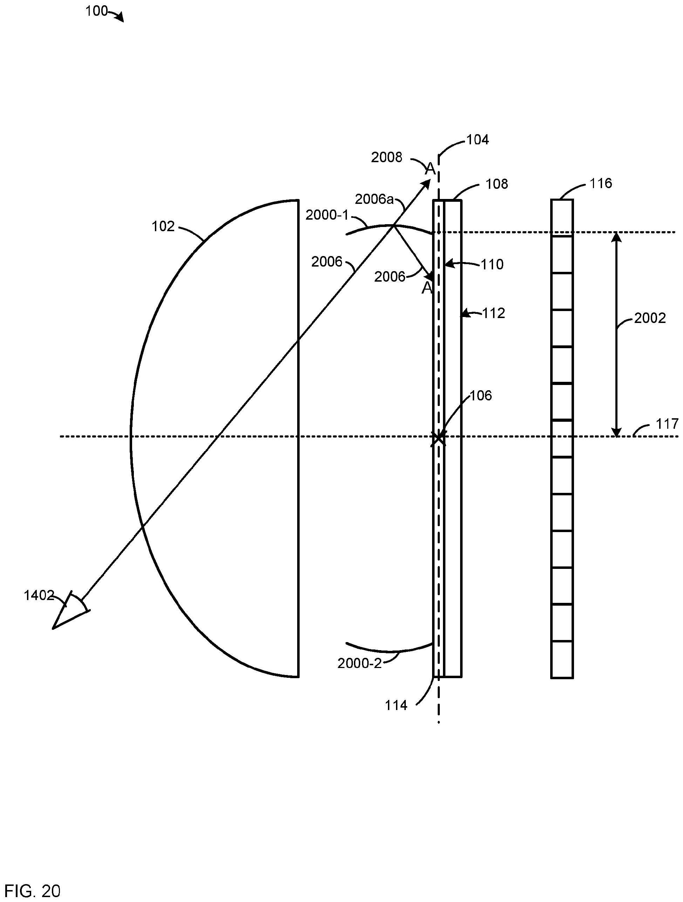

It is further understood, however, that "how much" of the image 114 the viewer 1402 views may be dependent on how close the viewer 1402 is to the system 1300, as the devices 100 may have respective, but similar, viewing angles that may limit "how much" of an image 114 a viewer may "see" at any given device 100. Indeed, in some examples, a device 100 may be adapted to extend a viewing angle thereof, described herein with respect to FIG. 20, FIG. 21 and FIG. 22.

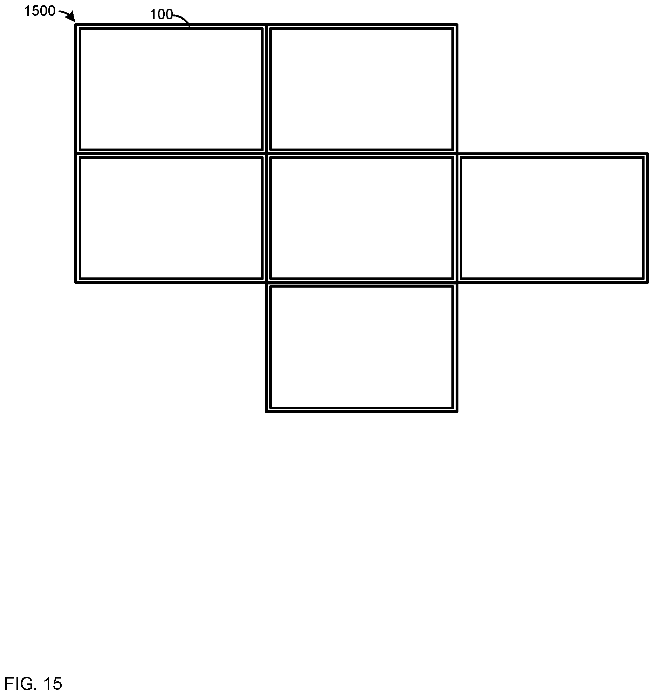

Attention is next directed to FIG. 15 which depicts another example of a system 1500 that includes an array of the devices 100. But rather than a symmetric array, as shown in FIG. 13, the system 1500 comprises an asymmetric array of the device 100 (e.g., different numbers of the devices 100 in respective rows and/or respective columns). The same optical effect described with respect to FIG. 14A, FIG. 14B, FIG. 14C, FIG. 14D, FIG. 14E and FIG. 14F is understood to generally occur at the system 1500, however parts of the image 114 may appear to obscured and/or may not be visible.

Another feature of the system 1300 and/or the system 1500 is that the respective images 114 are located at respective focal planes 104 and/or respective focal points 106, and as the collimated light 204 is collimated, features of the respective images 114 will not appear to move relative to each other as a viewer moves. Rather, as the respective images 114 are at an optical infinity, different portions of the respective images 114 are viewed by a viewer as the viewer moves, but such features do not appear to move relative to each other.

Furthermore, total brightness and/or total illuminance of light emitted by the plurality of the devices 100 of the system 1300 and/or the system 1500 may have peak intensities of greater than 30,000 nits (e.g., drastically brighter than flat panel displays of prior art devices). Put another way, the lamps 116 may be selected such that, when a plurality of the devices 100 are tiled, a total intensity of light emitted by the plurality of the devices 100 may be greater than 30,000 nits, excluding light emitted by those lamps 116 that are specifically controlled to mimic the sun. Similarly, particular lamps of the plurality of the devices 100 which may be used to specifically mimic the sun, may have total brightness and/or total illuminance greater than 1,000,000 nits, but which may be "concentrated" in regions of the plurality of devices 100 where such lamps 116 are located (e.g., such as the larger lamps 604). Indeed, the lamps 116 that are being controlled to mimic the sun may have a total specular brightness of greater than 1,000,000 nits, and other lamps 116 providing light meant to mimic sunlight scattered by the atmosphere, may have a total brightness and/or total illuminance of greater than 30,000 nits. Indeed, all of the devices 100 contribute to such total brightnesses and/or total illuminance, the lamps 116 of individual devices 100 are understood to emit only a fraction of such total brightnesses and/or total illuminances, and hence such lamps 116 may be cheaper, lower power, and easier to cool than lamps and/or flat panel displays of prior art devices. Indeed, flat panel displays of prior art devices may be incapable of emitting light at such brightness levels, and/or operating such flat panel displays at such brightness levels may reduce the lifetime of such flat panel displays.

The device 100 may include any other suitable features, as is next described.

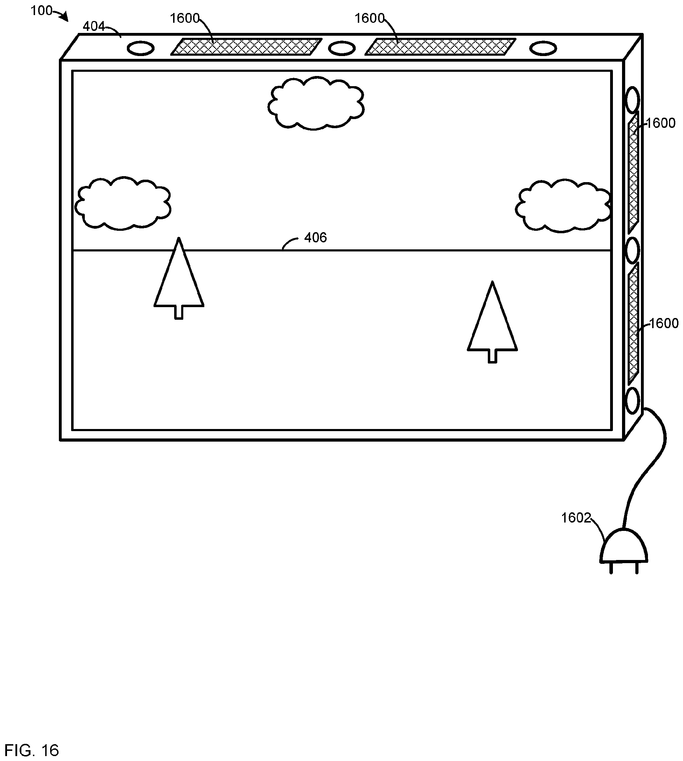

For example, with reference to FIG. 16, which is substantially similar to FIG 9, though not all features are numbered for simplicity, the device 100 may comprise one or more cooling ports 1600 through any suitable side and/or surface of the housing 904 (e.g., top, bottom left, right and/or back sides), through which air may flow to cool the at least one lamp 116. Indeed, the device 100 may comprise any suitable cooling components, including, but not limited to, the one or more cooling ports 1600, one or more (internal or external) fans for causing air to flow through the cooling ports 1600, amongst other possibilities. As depicted, the device 100 further comprises an external plug and/or electrical connector 1602 for connecting the power supply 706 with a mains power supply, and/or to a suitable power supply (e.g., a "low" voltage power supply that supplies voltages compatible with PoE powers and/or voltages (e.g., 24V, 48V, DC (direct current)) and the like, however the electrical connector 1602 may be replaced by any suitable connection to any suitable power supply and/or for connecting to a corresponding connector of an adjacent tiled device 100.

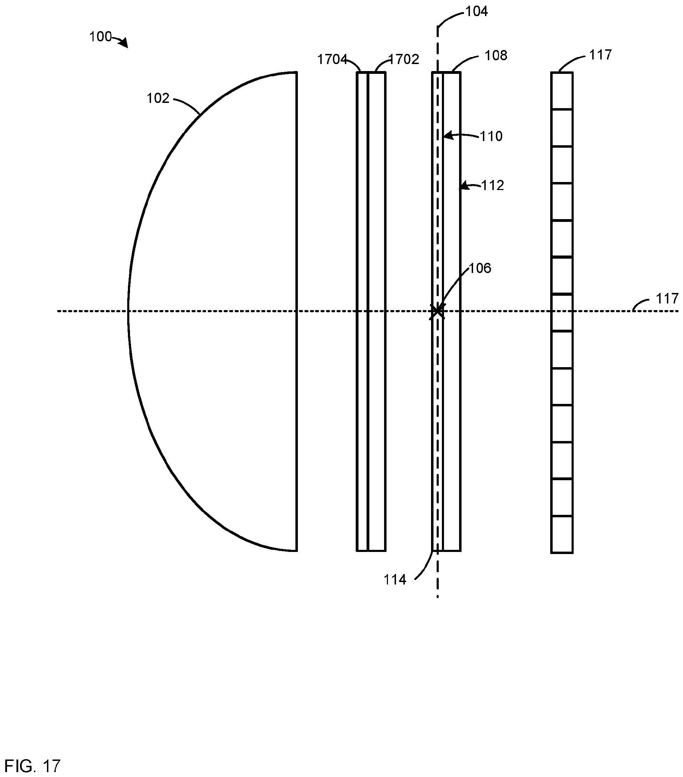

Attention is next directed to FIG. 17 which is substantially similar to FIG. 1, with like components having like numbers, however, in this example, the device 100 further comprises a second sheet 1702 located between the sheet 108 and the collimating lens 102, the second sheet 1702 being transparent, and including a respective image 1704 thereupon that may be smaller than the second sheet 108.

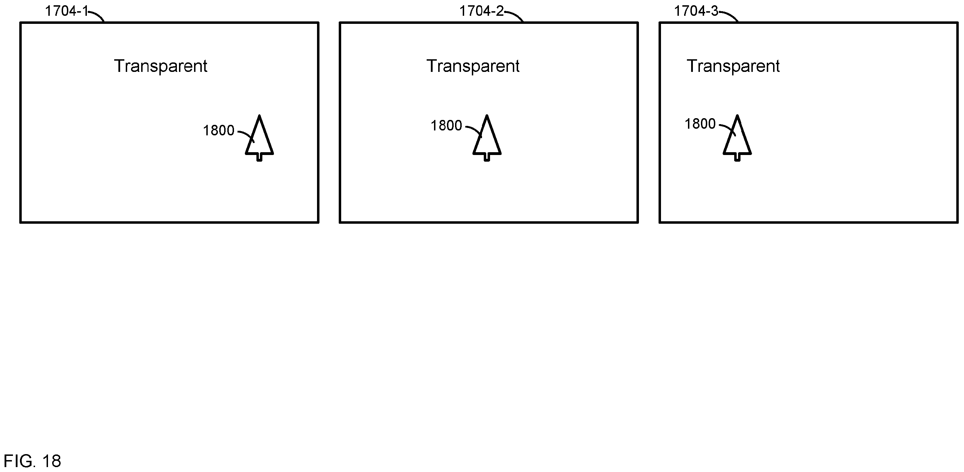

For example, with reference to FIG. 18, which depicts three examples of an image 1704-1, 1704-2, 1704-3 (e.g., images 1704 and/or an image 1704), each of which include an image of a tree 1800, though the images 1704 may include any suitable features. The images 1704 are otherwise transparent such that the image 114 is viewable through the images 1704 when incorporated into the device 100 as depicted in FIG. 17. While the word "Transparent" is shown for clarity, it is understood that the word does not generally appear in the image 1704.

Put another way, the second sheet 1702 may be same or different size and/or shape as the sheet 108, for ease of mounting within the housing 904, and image 1704 may be substantially transparent other than where features, such as the tree 1800, are located; hence, the respective image 1704 may be smaller than the second sheet 108 at least by virtue of being substantially transparent other than where features, such as the tree 1800, are located.

As has been previously described, as the image 114 is at an optical infinity, different portions of the image 114 are understood to be viewed by a viewer as the viewer moves, but features of the image 114 do not appear to move relative to each other. In contrast, as the image of the tree 1800 is in front of the image 114 and is not located at the focal plane 104 and/or the focal point 106, the image of the tree 1800 is not located at an optical infinity. As such, as a viewer moves, the image of the tree 1800 will appear to move relative to the features of the image 114. For example, with reference to the image 1704-1, as a viewer moves left to right, the tree 1800 will appear to move right to left. Such movement may be problematic when a plurality of the devices 100, as depicted in FIG. 17, are incorporated into a system of tiled devices 100.

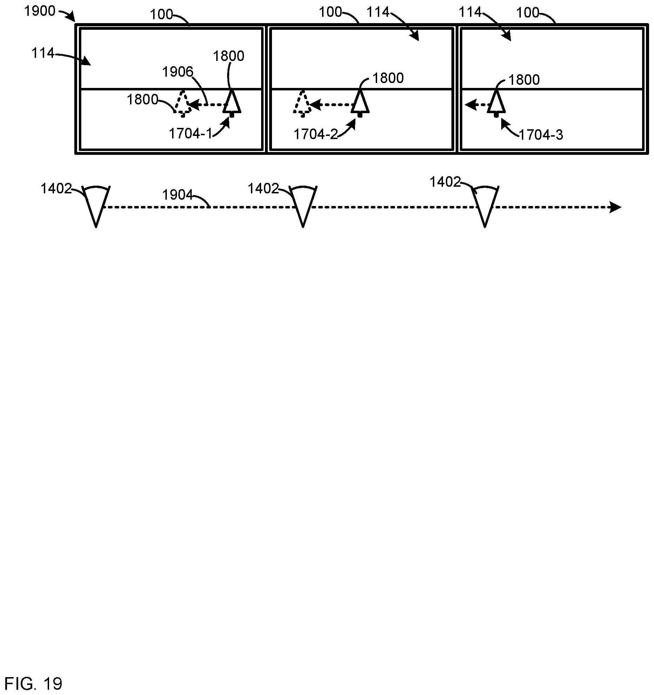

For example, attention is next directed to FIG. 19 which depicts a system 1900 comprising three tiled devices 100, as depicted in FIG. 17, in a row, with a leftmost device 100 having the image 1704-1 at the sheet 108, the middle device 100 having the image 1704-2 at the sheet 108, and the rightmost device 100 having the image 1704-3 at the sheet 108. While only a horizon line 406 of the image 114 of FIG. 4 is depicted for simplicity, other features of the image 114 may nonetheless be present. The respective trees 1800 of the images 1704 are also depicted.

Also depicted is a representation of the viewer 1402, who is depicted as moving left to right while viewing the images 1704-1, 1704-2, 1704-3, as represented by the viewer 1402 being located at different positions along a dashed arrow 1904.

As the viewer 1402 is initially viewing the leftmost device 100 from a left side of the leftmost device 100, the viewer 1402 sees the tree 1800 of the image 1704-1 at the rightmost side of the leftmost device 100, and as the viewer 1402 moves to the right, the viewer 1402 views the tree 1800 moving to the left, as indicated by the dashed arrow 1906. When the viewer 1402 reaches the rightmost side of the leftmost device 100, the tree 1800 may be at the position indicated by the dashed version of the tree 1800 at the leftmost device 100. When the viewer 1402 moves further enough along the arrow 1904, such that the viewer is now viewing the middle device 100, it is understood that the tree 1800 of the image 1704-2 is positioned in the image 1704-2, such that the tree 1800 is at the same position, relative to the viewer 1402, as the dashed version of the tree 1800 at the leftmost device 100 so that there is continuity between a position of the tree 1800 whether viewed at the leftmost device 100 or the middle device 100 as the viewer 1402 is moving left to right.

Similarly, when the viewer 1402 reaches the rightmost side of the middle device 100, the tree 1800 of the image 1704-2 may be at the position indicated by the dashed version of the tree 1800 at middle device 100. When the viewer 1402 moves further enough along the dashed arrow 1904, such that the viewer is now viewing the rightmost device 100, it is understood that the tree 1800 of the image 1704-3 is positioned in the image 1704-3 such that the tree 1800 is at the same position, relative to the viewer 1402, as the dashed version of the tree 1800 at the middle device 100 so that there is continuity between a position of the tree 1800 whether viewed at the middle device 100 or the rightmost device 100 as the viewer 1402 is moving left to right.

Hence, it is understood that the image 1704 at the second sheet 1702 may be adapted depending on a position of a respective device 100 in an array of tiled devices 100 such that viewing continuity of features of respective images 1704 thereof is maintained as a viewer moves relative to the array of tiled devices 100.

It is further understood that as the viewer 1402 moves as described with respect to FIG. 19, the viewer 1402 views portions of the image 114 in a manner similar to as described with respect to FIG. 14A, FIG. 14B, FIG. 14C, FIG. 14D, FIG. 14E, and FIG. 14F.

Attention is next directed to FIG. 20, which is substantially similar to FIG. 1, with like components having like numbers, however, in this example, the device 100 further comprises at least one mirror 2000-1, 2000-2 (e.g., mirrors 2000 and a mirror 2000) extending from the sheet 108 (and/or the image 114) part way towards the collimating lens 102, the at least one mirror 2000 located at a given distance 2002 from the focal point 106, for example perpendicular to the center axis 117 of the lens 102. While as depicted the mirrors 2000 are concave, in other examples, the mirrors 2000 may be flat and/or convex, and/or the mirrors 2000 may be any suitable combination of concave, flat and convex.

As depicted, there are two mirrors 2000 symmetrically arranged around the central axis 117. Furthermore, while two mirrors 2000 are depicted, there may be as few as one mirror 2000 (e.g., one of the mirrors 2000-1, 2000-2), and/or or there may be one, or two, additional mirrors perpendicular to the mirrors 2000 and arranged in and/or out of the page of FIG. 20. In particular the mirrors 2000 are understood to extend a viewing angle of the device 100 in up/down directions, and the like, and additional mirrors additional mirrors perpendicular to the mirrors 2000 may be to extend a viewing angle of the device 100 in left/right directions, and the like.

For example, as depicted, the viewer 1402 is viewing the device 100 at an angle, looking "up" at the image 114 through the lens 102, along a path 2006 that reflects from the mirror 2000-1 to view a point "A" of the image 114. However, the viewer 1402 "sees" the point "A" at a position 2008, past an end of the image 114, along a vector 2006a that extends straight into the mirror 2000-1 from the viewer 1402, thereby extending the viewing angle of the device 100, which would otherwise be limited to an end of the image 114. A similar effect occurs when the viewer 1402 is viewing the device 100 via the mirror 2000-2.

It is further understood that in examples described heretofore, the sheet 108 and the image 114 are about parallel to the lens 102.

However, in other examples, a mirror may be used to extend the viewing angle of the device 100 by rotating the sheet 108, the image 114 and the at least one lamp 116 relative to the lens 102.

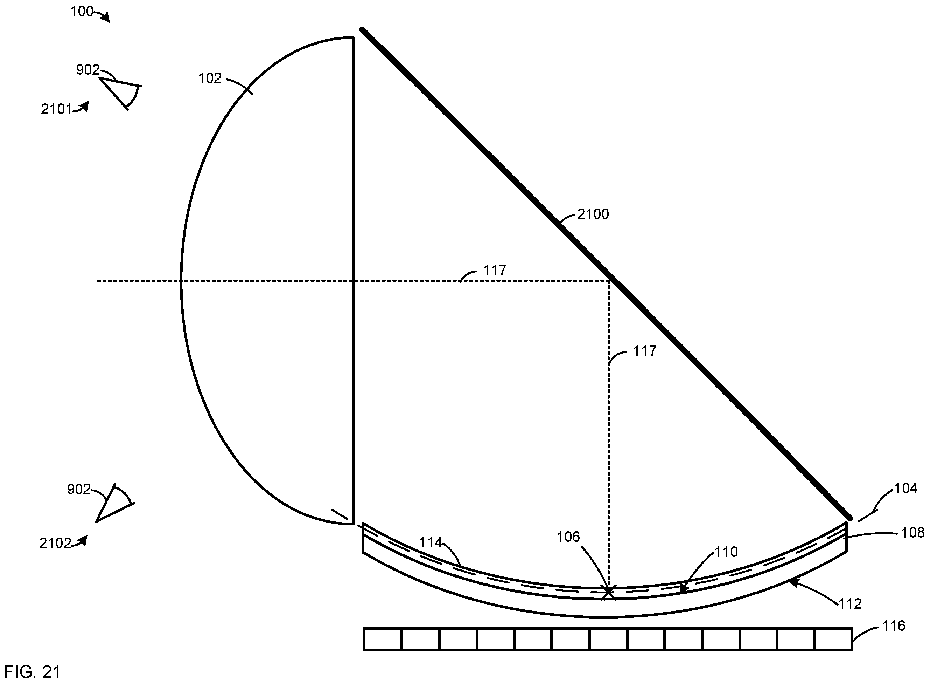

Attention is next directed to FIG. 21, which is substantially similar to FIG. 3, with like components having like numbers, however, in this example, the device 100 further comprises a mirror 2100, and the mirror 2100, the collimating lens 102 and the sheet 108 (e.g., and the image 114) are arranged such that the mirror 2100 reflects the image 114 towards the collimating lens 102, such that the image 114 of the sheet 108 is about located at the focal plane 104 of the collimating lens 102 via the mirror 2100. For example, as depicted, the sheet 108, the image 114 and the least one lamp 116 are about perpendicular to the collimating lens 102, and at end of the collimating lens 102, and the mirror 2100 extends from an opposite end of the collimating lens 102 to a respective end of the sheet 108 that is furthest from the collimating lens 102. In some examples, the mirror 2100 may form an about 45° angle with a back side of the lens 102 and/or the front side 110 of the sheet 108, though the mirror 2100 may be at any suitable angle. Such a mirror 2100 effectively "bends" the center axis 117 of the lens 102, and reflects the focal plane 104 and the focal point 106, such that the focal point 106 remains on the center axis 117 and the center axis 117 remains normal to the focal plane 104, the sheet 108 and the image 114.

Such an optical arrangement will enable the image 114 to be viewed at larger angles than the arrangement depicted in FIG. 1. For example, the viewer 1402 at a viewing angle and position 2101 will view the image 114 not via the mirror 2100 and the viewer 1402 at a viewing angle and position 2102 will view the image 114 via the mirror 2100, which effectively about doubles the viewing angle of the device 100. F

It is understood, however, that such an arrangement may place some restrictions on the image 114 and/or the at least one lamp 116. For example, as depicted, the mirror 2100 is arranged to double the viewing angle of the image 114 along the curved direction of the focal plane 104, the sheet 108 and the image 114. Hence, when the image 114 is as depicted in FIG. 4, and includes the sky portion 402, the ground portion 404 and the horizon line 406, the landscape depicted in FIG. 4 is effectively doubled and/or mirrored with respect to the viewer 1402.

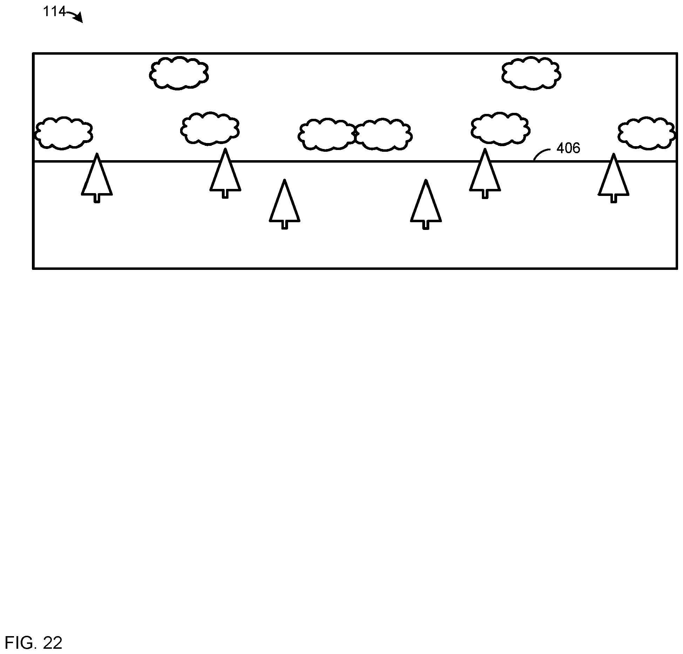

For example, attention is directed to FIG. 22 which depicts the image 114 of FIG. 4 being doubled and/or mirrored along a direction of the horizon line 406 due to the mirror 2100, however it is understood that not all the doubled image 114 is viewable by the viewer 1402 at a given position. Rather, as the viewer 1402 moves, different portions of the doubled image 114 are viewed by the viewer 1402.

However, if the mirror were rotated to double the image 114 perpendicular to the horizon line 406, the image 114 would be doubled in a manner that causes the viewer 1402 to view two sky portions 402, two ground portions 404 and two horizon lines 406. Hence, when the device 100 is intended to be used as an artificial window, the mirror 2100 may be arranged to double and/or mirror the image 114 along the horizon line 406 and not perpendicular to the horizon line 406. Such restrictions are generally not applicable to the image as depicted in FIG. 5, however, and hence when the device 100 is intended to be used as an artificial skylight, such the image 114 includes only a sky portion 502, the mirror 2100 may be arranged to double the image 114 in any suitable direction.

Similarly, if the at least one lamp 116 were operated as described with respect to FIG. 8, FIG. 9, FIG. 10, and FIG. 11, the viewer 1402 might view two "suns", regardless of whether the device 100 of FIG. 21 was used as an artificial window or an artificial skylight. Hence, some of these examples, all of lamps 116, of the at least one lamps 116, may be controlled to achieve similar brightness and/or similar color temperature, though it is understood that brightness and/or color temperature of the lamps 116 may be changed, as whole, to mimic changes in brightness and/or color temperature throughout a day, but without specifically controlling any of the lamps 116 to mimic the sun. However, the "two suns" problem may be obviated by locating a lamp 116, such as the larger lamp 604-1 at a position that is adjacent the mirror 2100, and/or at an end of an array of the lamps 116 that is adjacent the mirror 2100, such that the viewer 1402 views an extended "blob" and/or circle of light, rather than two blobs and/or circles of light; put another way, when a lamp 116 is located in such a position, and such a lamp 116 is operated to be brighter than the other lamps 116, such a lamp 116 and the reflection of such a lamp 116 are adjacent and may be viewed as one "blob" of light that is brighter than the light from the other lamps 116.

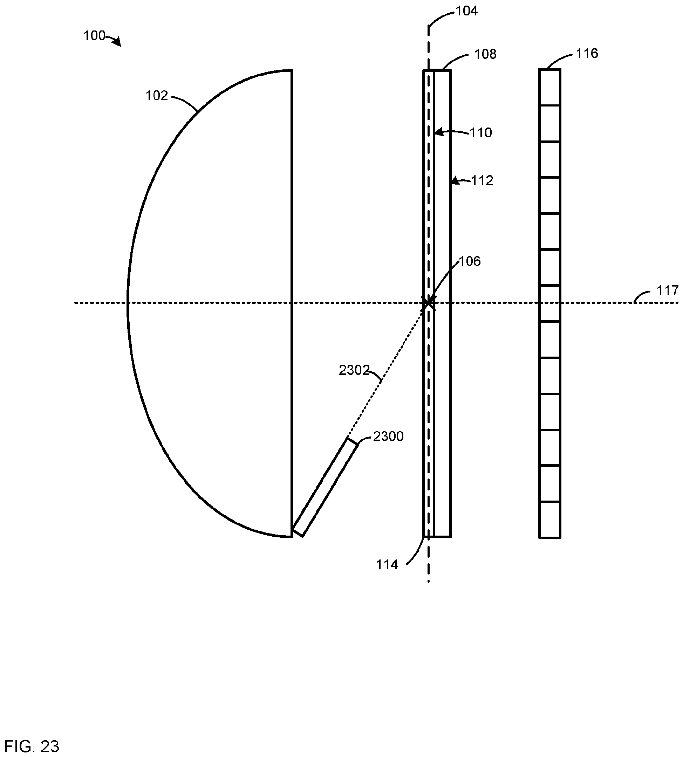

Attention is next directed to FIG. 23, which is substantially similar to FIG. 1, with like components having like numbers, however, in this example, the device 100 further comprises a planar component 2300 between the collimating lens 102 and the sheet 108 (e.g., and/or the image 114), the planar component 2300 extending from an edge of the collimating lens 102 at least partially towards the focal point 106, for example along a path 2302 that extends from an edge of the lens 102 to the focal point 106. The planar component 2300 is understood to extend only part way towards the focal point 106 as otherwise the planar component 2300 may obscure a view of a portion of the image 114, for example, the planar component 2300 may extend 5%, 10%, 15%, amongst other possibilities, of a distance from an edge of the collimating lens 102 to the focal point 106.

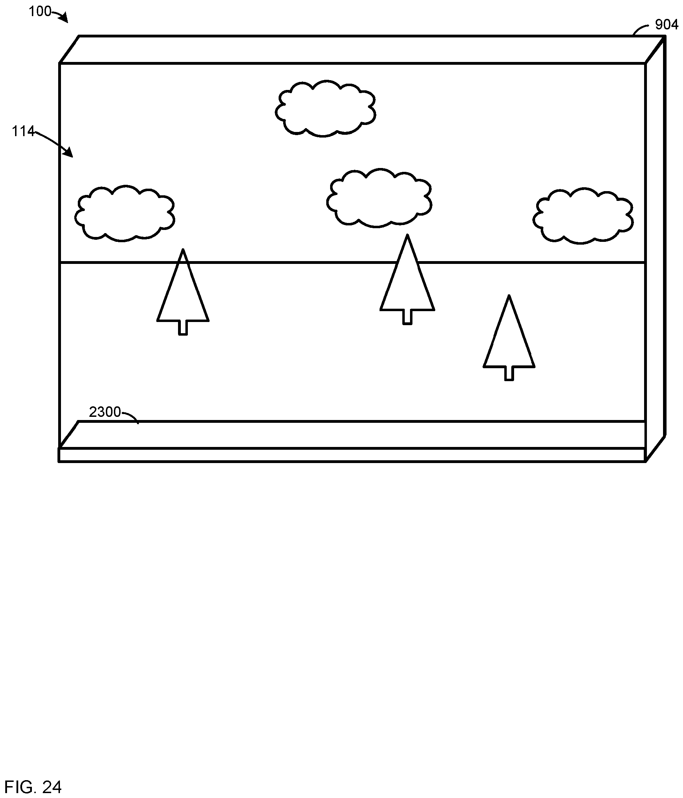

Furthermore, while only one planar component 2300 is depicted, the device 100 may alternatively, or in addition, comprise a second planar component extending from an opposite end of the lens 102 towards the focal point 106, and/or similarly, the device 100 may comprise one or two additional planar components perpendicular to the planar component 2300 and arranged in and/or out of the page of FIG. 23 and otherwise extending from respective ends of the lens 102 towards the focal point 106. In particular, the planar component 2300 may provide an optical illusion of a mullion for an artificial mirror and/or artificial skylight as is next described with respect to FIG. 24, which depicts a perspective view of the device 100 of FIG. 23.

In particular, in FIG. 24, the housing 904 of the device 100 has been adapted such that there is no frame 910. Rather, the image 114 is viewable from edge to edge of the device 100 through the lens 102. Such implementations of the device 100 may be tiled into an array without mullions provided by the frame 910. However, when a mullion is preferred, the planar component 2300 may be provided, which, when viewed through the lens 102, appears to extend perpendicularly from an edge of the lens 102 towards the image 114. Such an optical effect occurs as the planar component 2300 extends from an edge of the lens 102 towards the focal point 106 within the device 100. Hence, the planar component 2300 appears as a mullion at the bottom internal edge of the device 100, though other planar components may be provided at other edges of the lens 102 to provide "mullions" along the other internal edges of the device 100.

Furthermore, it is understood that while the planar component 2300 is depicted as flat, the planar component 2300 may include a curve, for example to compensate for optical properties of the lens 102 such that, to a viewer, the planar component 2300 appears flat via the front of the device 100.

Furthermore, a similar planar component may be used to provide an alternative illumination of an image.

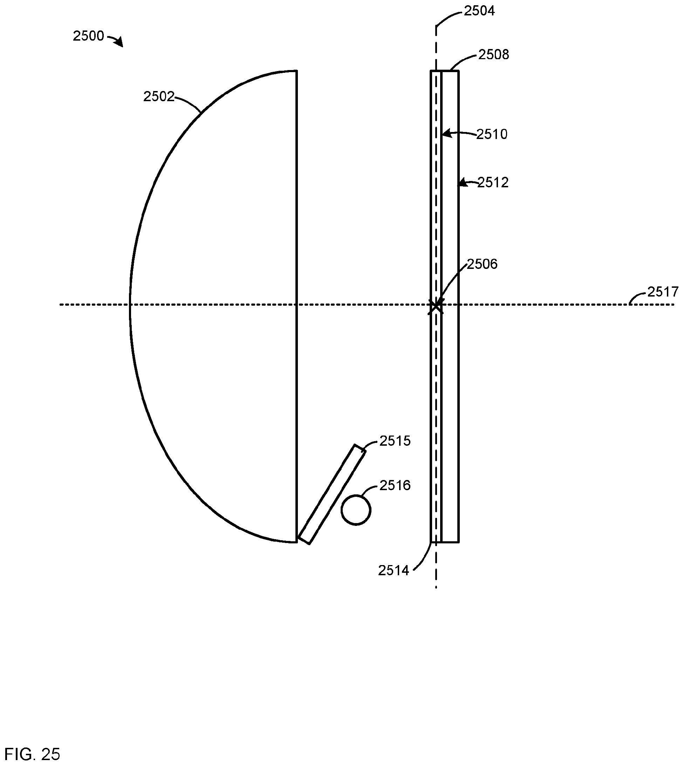

For example, attention is next directed to FIG. 25 which depicts a device 2500 which is substantially similar to the device 100 as depicted in FIG. 1, with like components having like numbers, but in a "2500" series rather than a "100" series.

For example, the device 2500 comprises: a collimating lens 2502 having a focal plane 2504 and a focal point 2506 located in the focal plane 2504, wherein the focal plane 2504 is flat or curved dependent on given optical properties of the collimating lens 2502; a sheet 2508 having a lens-facing front side 2510 and a back side 2512 opposite the lens-facing front side 2510 having an image 2514 thereat, at least at the lens-facing front side 2510, the image 2514 on the sheet located at about the focal plane 2504 of the collimating lens 2502; a planar component 2515 between the collimating lens 2502 and the sheet 2508 (e.g., and/or the image 2514), the planar component 2515 extending from an edge of the collimating lens 2502 at least partially towards the focal point 2506, and at least one lamp 2516 behind the a planar component 2515, relative to the collimating lens 2502, the at least one lamp 2516 between the collimating lens 2502 and the sheet 2508. A center axis 2517 of the lens 2502 is also depicted.

In general, the lens 2502, the focal plane 2504, the focal point 2506, the sheet 2508, the image 2514, and the center axis 2517 are understood to be respectively similar to the lens 102, the focal plane 104, the focal point 106, the sheet 108, the image 114, and the center axis 117 other than as described hereafter. Similarly, the planar component 2515 is understood to be similar to the planar component 2300 other than as described hereafter. Furthermore, while a housing is not depicted, the device 2500 is understood to comprise a housing, similar to the housing 904 and/or any other suitable features of the device 100, including, but not limited to, mounting components and/or tiling components, etc.

In contrast to the device 100, as the at least one lamp 2516 is located between the collimating lens 2502 and the sheet 2508, the sheet 2508 and the image 2514 may not be at least semitransparent and/or translucent, but rather may be opaque.

Furthermore, the planar component 2515 may be opaque or at least semitransparent and/or translucent.

When the planar component 2515 is opaque, the at least one lamp 2516 may be arranged to illuminate the image 2514 directly, for example with light emitted from the at least one lamp 2516 shining, substantially uniformly, onto the image 2514. In these examples, the at least one lamp 2516 may comprise one lamp, or a line of lamps 2516 that extend into, and/or out of, the page of FIG. 25. In general, in these examples, the planar component 2515 "hides" the at least one lamp 2516 from a viewer. The viewer will hence view the planar component 2515 similar to as depicted in FIG. 24, with the planar component 2515 acting as a mullion, similar to the planar component 2300.

When the planar component 2515 is at least semitransparent and/or translucent, the planar component 2515 may be formed from a light scattering material and/or may a light-emitting material which, for example, fluoresces, and the like, when illuminated by the at least one lamp 2516 (e.g., with a color and/or wavelengths of the at least one lamp 2516 selected accordingly to be in a range that causes the light-emitting material to fluoresce). In these examples, the at least one lamp 2516 may be arranged to illuminate the planar component 2515, such that the planar component 2515 illuminates the image 2514 via scattering of light from the at least one lamp 2516 and/or fluorescence, and that illuminates the planar component 2515 at a side opposite the lens 2502.

In these examples, the at least one lamp 2516 may comprise one lamp, or a line of lamps 2516 that extend into, and/or out of, the page of FIG. 25. In general, in these examples, the planar component 2515 "hides" the at least one lamp 2516 from a viewer but also illuminates the image 2514. The viewer will hence view the planar component 2515 similar to as depicted in FIG. 24, with the planar component 2515 acting as a mullion, similar to the planar component 2300; however, the planar component 2515 will also appear to the viewer as emitting light.

In these examples, the at least one lamp 2516 may be controlled similar to as described with respect to the at least one lamp 2516 with respect to changing brightness and/or color temperature over a time period corresponding to a day, and the like, but without specifically mimicking the sun.

It is further understood that while the device 2500 is depicted with one planar component 2515 and one corresponding at least one lamp 2516 in a particular position, it is understood that the device 2500 may alternatively, or in addition, comprise other planar components 2515 and other corresponding at least one lamps 2516 in any other suitable positions.

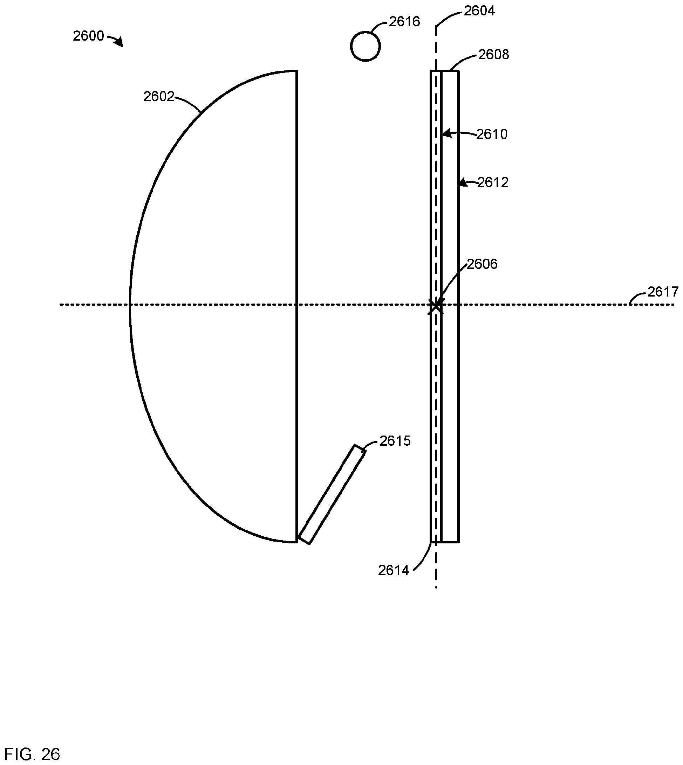

Attention is next directed to FIG. 26 which depicts a device 2600 which is substantially similar to the device 2500 as depicted in FIG. 25, with like components having like numbers, but in a "2600" series rather than a "2500" series.

For example, the device 2600 comprises: a collimating lens 2602 having a focal plane 2604 and a focal point 2606 located in the focal plane 2604, wherein the focal plane 2604 is flat or curved dependent on given optical properties of the collimating lens 2602; a sheet 2608 having a lens-facing front side 2610 and a back side 2612 opposite the lens-facing front side 2610 having an image 2614 there at least at the lens-facing front side 2610, the image 2614 on the sheet located at the focal plane 2604 of the collimating lens 2602; an optional planar component 2615 between the collimating lens 2602 and the sheet 2608 (e.g., and/or the image 2614), the optional planar component 2615 extending from an edge of the collimating lens 2602 at least partially towards the focal point 2606, and at least one lamp 2616 located at an opposite end of the lens as the planar component 2615, relative to the collimating lens 2602, the at least one lamp 2616 positioned to substantially uniformly illuminate the image 2614, and optionally the optional planar component 2615 which may assist at illuminating the image 2614, for example via light scattering, fluorescence, and the like. A center axis 2617 of the lens 2602 is also depicted.

The at least one lamp 2516 is further understood to be positioned outside of a region between the lens 2602 and the sheet 2608 such that at least one lamp 2516 is not viewable (e.g., by a viewer) through the lens 2502.

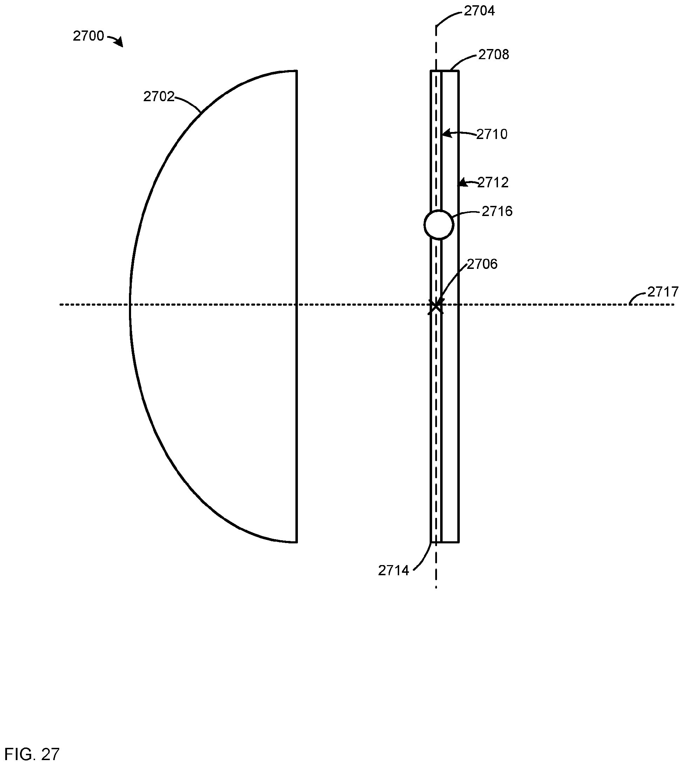

Attention is next directed to FIG. 27 which depicts a device 2700 which is substantially similar to the device 2500 as depicted in FIG. 25, with like components having like numbers, but in a "2700" series rather than a "2500" series.

For example, the device 2700 comprises: a collimating lens 2702 having a focal plane 2704 and a focal point 2704 located in the focal plane 2706, wherein the focal plane 2704 is flat or curved dependent on given optical properties of the collimating lens 2702; a sheet 2708 having a lens-facing front side 2710 and a back side 2712 opposite the lens-facing front side 2710 having an image 2714 thereat, at least at the lens-facing front side 2710, the image 2714 on the sheet located at about the focal plane 2704 of the collimating lens 2702; and at least one lamp 2716 embedded in the sheet 2708, the at least one lamp 2716 configured to illuminate the image 2714. In some examples, the at least one lamp 2716 may be positioned to mimic the sun at one particular time of day. A center axis 2717 of the lens 2702 is also depicted. However, as at least one lamp 2716 may not sufficiently illuminate the image 2714, the device 2700 may further include a lamp similar to the lamp 2616 to substantially illuminate the image 2714

Hence, it is further understood that the various illumination schemes provided herein, may be combined in any suitable manner. For example, a device as provided herein may be similar to the device 100, with at least one lamp behind an at least partially transparent sheet, but include a planar component hiding another at least one lamp similar to the device 2500. Indeed, any of the illumination schemes of the devices 100, 2500, 2600, 2700 may be combined in any suitable manner.

In particular, the device 100 may be combined with features of the device 2600 and/or the device 2700. For example, the device 100 may be modified to combine the at least one lamp 116, that provides light 200 transmitted through the image 114, with the at least one lamp, similar to the at least one lamp 2616, that illuminates the image 114 from a "front" side of the image 114. In some of these examples, the device 100 may include a lamp, similar to the lamp 2716, embedded in a surface of the image 114 at a position that corresponds to a position of the sun.

In this specification, elements may be described as "configured to" perform one or more functions or "configured for" such functions. In general, an element that is configured to perform or configured for performing a function is enabled to perform the function, or is suitable for performing the function, or is adapted to perform the function, or is operable to perform the function, or is otherwise capable of performing the function.

It is understood that for the purpose of this specification, language of "at least one of X, Y, and Z" and "one or more of X, Y and Z" can be construed as X only, Y only, Z only, or any combination of two or more items X, Y, and Z (e.g., XYZ, XY, YZ, XZ, and the like). Similar logic can be applied for two or more items in any occurrence of "at least one..." and "one or more..." language.

The terms "about", "substantially", "essentially", "approximately", and the like, are defined as being "close to", for example as understood by persons of skill in the art. In some examples, the terms are understood to be "within 10%," in other examples, "within 5%", in yet further examples, "within 1%", and in yet further examples "within 0.5%".

Furthermore, relational terms such as height, width, up, down, left, right, vertical, horizontal, and the like, may be used solely to distinguish one component, or portion of a component, from another component, or another portion of a component without necessarily requiring or implying any actual such relationship or order between such components. For example, a device described as being used in a horizontal manner may be rotated and used in a vertical manner, and the like.

Persons skilled in the art will appreciate that in some examples, the functionality of devices and/or methods and/or processes described herein can be implemented using pre-programmed hardware or firmware elements (e.g., application specific integrated circuits (ASICs, FPGAs, and/or Raspberry Pi^{™} and/or Arduino^{™} type devices), electrically erasable programmable read-only memories (EEPROMs), etc.), or other related components. In other examples, the functionality of the devices and/or methods and/or processes described herein can be achieved using a computing apparatus that has access to a code memory (not shown) which stores computer-readable program code for operation of the computing apparatus. The computer-readable program code could be stored on a computer readable storage medium which is fixed, tangible and readable directly by these components, (e.g., removable diskette, CD-ROM, ROM, fixed disk, USB drive). Furthermore, it is appreciated that the computer-readable program can be stored as a computer program product comprising a computer usable medium. Further, a persistent storage device can comprise the computer readable program code. It is yet further appreciated that the computer-readable program code and/or computer usable medium can comprise a non-transitory computer-readable program code and/or non-transitory computer usable medium. Alternatively, the computer-readable program code could be stored remotely but transmittable to these components via a modem or other interface device connected to a network (including, without limitation, the Internet) over a transmission medium. The transmission medium can be either a non-mobile medium (e.g., optical and/or digital and/or analog communications lines) or a mobile medium (e.g., microwave, infrared, free-space optical or other transmission schemes) or a combination thereof.

Persons skilled in the art will appreciate that there are yet more alternative examples and modifications possible, and that the above examples are only illustrations of one or more examples. The scope, therefore, is only to be limited by the claims appended hereto.

Examples of the present invention are set forth below.

Example 1. A device comprising:
a collimating lens having a focal plane and a focal point located in the focal plane, wherein the focal plane is flat or curved dependent on given optical properties of the collimating lens;
a sheet having a lens-facing front side and a back side opposite the lens-facing front side, the sheet being semi-transparent and having an image thereat, at least at about the lens-facing front side, the image of the sheet located at about the focal plane of the collimating lens; and
at least one lamp located at the back side of the sheet such that the sheet is between the collimating lens and the at least one lamp, the at least one lamp configured to emit light towards the back side of the sheet, at least a portion of the light transmitted through the sheet towards the collimating lens.

Example 2. The device of example 1, wherein the collimating lens comprises a Fresnel lens.

Example 3. The device of example 1 or 2, wherein the sheet is flat or curved according to one or more of the focal plane and the given optical properties of the collimating lens.

Example 4. The device of one of examples 1 to 3, wherein a center of the image is about located at about the focal point of the collimating lens.

Example 5. The device of one of examples 1 to 4, wherein the image comprises a horizon line that intersects the focal point of the collimating lens.

Example 6. The device of one of examples 1 to 5, wherein the at least one lamp comprises at least one light emitting diode.

Example 7. The device of one of examples 1 to 6, wherein the at least one lamp comprises an array of lamps configured to illuminate the image about uniformly.

Example 8. The device of claim one of examples 1 to 7, further comprising a controller, wherein the at least one lamp comprises a plurality of lamps at different respective locations relative to the sheet, and the controller is configured to respectively brighten and dim individual lamps of the plurality of lamps according to one or more of a time of day, one or more given brightness levels and one or more given color temperatures.

Example 9. The device of one of examples 1 to 8, further comprising a controller, wherein the at least one lamp comprises a plurality of lamps arranged at different respective locations along a line or arc relative to one or more of the sheet and a horizon line of the image, the plurality of lamps including a first lamp and a last lamp located at opposite ends of the line or the arc, and the controller is configured to:
at respective times of day brighten a respective lamp in succession along the line or, arc starting with the first lamp and ending with the last lamp, and dim any other lamps of the plurality of lamps when a given lamp is brightened.

Example 10. The device of example 9, wherein the at least one lamp further comprise an array of lamps in addition to the plurality of lamps arranged along the line or arc, and wherein the controller is further configured to:
maintain a respective brightness of the array of lamps while given lamps of the plurality of lamps are being brightened or dimmed; and
when the any other lamps of the plurality of lamps are being dimmed, dim the any other lamps to the respective brightness of the array of lamps.

Example 11. The device of one of examples 1 to 10, further comprising a mirror, wherein the mirror, the collimating lens and the sheet are arranged such that the mirror reflects the image towards the collimating lens, such that the image of the sheet is about located at about the focal plane of the collimating lens via the mirror.

Example 12. The device of one of examples 1 to 11, wherein the sheet, and the image are about perpendicular to the collimating lens.

Example 13. The device of one of examples 1 to 12, wherein the sheet is about parallel to the collimating lens, the device further comprising a planar component between the collimating lens and the sheet, the planar component extending from an edge of the collimating lens at least partially towards the focal point.

Example 14. The device of one of examples 1 to 13, wherein the sheet is about parallel to the collimating lens, the device further comprising a mirror extending from the sheet part way towards the collimating lens, the mirror located at a given distance from the focal point.

Example 15. The device of one of examples 1 to 14, further comprising a second sheet located between the sheet and the collimating lens, the second sheet being transparent, and including a respective image thereupon that is smaller than the second sheet.

Example 16. The device of one of examples 1 to 15, further comprising a housing that supports the collimating lens, the sheet and the at least one lamp.

Example 17. The device of example 16, wherein the housing comprises one or more mounting components for mounting the collimating lens, the sheet and the at least one lamp on one or more of a wall and ceiling.

Example 18. The device of example 16, wherein the housing comprises one or more tiling components for tiling the device with other devices similar to the device.

Example 19. A system comprising:
a plurality of devices, each of the plurality of devices comprising:
a collimating lens having a focal plane and a focal point located in the focal plane, wherein the focal plane is flat or curved dependent on given optical properties of the collimating lens;
a sheet having a lens-facing front side and a back side opposite the lens-facing front side, the sheet being semi-transparent and having an image thereat, at least at the lens-facing front side, the image of the sheet located at about the focal plane of the collimating lens;
at least one lamp located at the back side of the sheet such that the sheet is between the collimating lens and the at least one lamp, the at least one lamp configured to emit light towards the back side of the sheet, at least a portion of the light transmitted through the sheet towards the collimating lens; and
a housing comprising one or more of:
   one or more mounting components for mounting the collimating lens, the sheet and the at least one lamp on one or more of a wall and ceiling; and
   one or more tiling components for tiling the device with others of the plurality of devices.

## Claims

1. A device comprising:
a collimating lens having a focal plane and a focal point located in the focal plane, wherein the focal plane is flat or curved dependent on given optical properties of the collimating lens;
a sheet having a lens-facing front side and a back side opposite the lens-facing front side, the sheet being semi-transparent and having an image thereat, at least at about the lens-facing front side, the image of the sheet located at about the focal plane of the collimating lens; and
at least one lamp located at the back side of the sheet such that the sheet is between the collimating lens and the at least one lamp, the at least one lamp configured to emit light towards the back side of the sheet, at least a portion of the light transmitted through the sheet towards the collimating lens.

2. The device of claim 1, wherein the collimating lens comprises a Fresnel lens.

3. The device of claim 1 or 2, wherein the sheet is flat or curved according to one or more of the focal plane and the given optical properties of the collimating lens.

4. The device of one of claims 1 to 3, wherein a center of the image is about located at about the focal point of the collimating lens.

5. The device of one of claims 1 to 4, wherein the image comprises a horizon line that intersects the focal point of the collimating lens.

6. The device of one of claims 1 to 5, wherein the at least one lamp comprises at least one light emitting diode, and/or an array of lamps configured to illuminate the image about uniformly.

7. The device of one of claims 1 to 6, further comprising a controller, wherein the at least one lamp comprises a plurality of lamps at different respective locations relative to the sheet, and the controller is configured to respectively brighten and dim individual lamps of the plurality of lamps according to one or more of a time of day, one or more given brightness levels and one or more given color temperatures.

8. The device of one of claims 1 to 7, further comprising a controller, wherein the at least one lamp comprises a plurality of lamps arranged at different respective locations along a line or arc relative to one or more of the sheet and a horizon line of the image, the plurality of lamps including a first lamp and a last lamp located at opposite ends of the line or the arc, and the controller is configured to:
at respective times of day brighten a respective lamp in succession along the line or, arc starting with the first lamp and ending with the last lamp, and dim any other lamps of the plurality of lamps when a given lamp is brightened.

9. The device of claim 8, wherein the at least one lamp further comprise an array of lamps in addition to the plurality of lamps arranged along the line or arc, and wherein the controller is further configured to:
maintain a respective brightness of the array of lamps while given lamps of the plurality of lamps are being brightened or dimmed; and
when the any other lamps of the plurality of lamps are being dimmed, dim the any other lamps to the respective brightness of the array of lamps.

10. The device of one of claims 1 to 9, further comprising a mirror, wherein the mirror, the collimating lens and the sheet are arranged such that the mirror reflects the image towards the collimating lens, such that the image of the sheet is about located at about the focal plane of the collimating lens via the mirror.

11. The device of one of claims 1 to 10, wherein the sheet, and the image are about perpendicular to the collimating lens.

12. The device of one of claims 1 to 11, wherein the sheet is about parallel to the collimating lens, the device further comprising a planar component between the collimating lens and the sheet, the planar component extending from an edge of the collimating lens at least partially towards the focal point.

13. The device of one of claims 1 to 12, wherein the sheet is about parallel to the collimating lens, the device further comprising a mirror extending from the sheet part way towards the collimating lens, the mirror located at a given distance from the focal point.

14. The device of one of claims 1 to 13, further comprising a second sheet located between the sheet and the collimating lens, the second sheet being transparent, and including a respective image thereupon that is smaller than the second sheet.

15. A system comprising:
a plurality of devices, each of the plurality of devices comprising the device of one of claims 1 to 14; and
a housing comprising one or more of:
one or more mounting components for mounting the collimating lens, the sheet and the at least one lamp on one or more of a wall and ceiling; and
one or more tiling components for tiling the device with others of the plurality of devices.
